(19) **Europäisches Patentamt European Patent Office Office européen des brevets**

(11) **EP 3 258 736 B1**

(12) **FASCICULE DE BREVET EUROPEEN**

(45) Date de publication et mention de la délivrance du brevet:
**29.07.2020 Bulletin 2020/31**

(51) Int Cl.:
*H04W 84/04* (2009.01)  *H04W 4/06* (2009.01)
*H04W 52/02* (2009.01)  *H04W 72/04* (2009.01)

(21) Numéro de dépôt: **17175414.6**

(22) Date de dépôt: **12.06.2017**

(54) **PROCEDE DE DEFINITION ET D'APPLICATION D'UN PLAN DE FREQUENCE**

VERFAHRENSWEISE DER DEFINITION UND DER ANWENDUNG EINES HÄUFIGKEITSPLANS

METHOD FOR DEFINING AND APPLYING A FREQUENCY PLAN

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **15.06.2016 FR 1655553**

(43) Date de publication de la demande:
**20.12.2017 Bulletin 2017/51**

(73) Titulaire: **Sagemcom Energy & Telecom SAS 92500 Rueil-Malmaison (FR)**

(72) Inventeurs:
• **SENNOUN, Yassir 92500 Rueil Malmaison (FR)**
• **HARNAY, Franck 92500 Rueil Malmaison (FR)**

(74) Mandataire: **Cabinet Le Guen Maillet 3, impasse de la Vigie CS 71840 35418 Saint-Malo Cedex (FR)**

(56) Documents cités:
• **Lora Alliance ET AL: "A technical overview of LoRa What is it?", , 31 mai 2016 (2016-05-31), XP055326494, Extrait de l'Internet: URL:http://www.semtech.com/wireless-rf/iot /LoRaWAN101_final.pdf [extrait le 2016-12-06]**
• **Patavina Technologies: "Patavina Technologies General Document Document ID: lorapt_system_architecture LoRa PT System Architecture", , 28 janvier 2016 (2016-01-28), XP055329352, Extrait de l'Internet: URL:http://www.patavinatech.com/pt/wp-cont ent/uploads/LoRaPTSystemArchitecture.pdf [extrait le 2016-12-15]**

## Description

La présente invention concerne une définition et une application d'un plan de fréquences dans un système de communication de type LPWAN.

L'Internet des Objets (« Internet of Things » en anglais) émerge. L'Internet des Objets représente l'extension de l'Internet à des choses et à des lieux du monde physique. Alors que l'Internet ne se prolonge habituellement pas au-delà du monde électronique, l'Internet des Objets représente des échanges d'informations et de données provenant de dispositifs présents dans le monde réel vers l'Internet, comme par exemple pour effectuer une collecte de relevés de consommations électriques ou de consommations d'eau, ou des collectes de mesures de capteurs d'une manière générale. L'Internet des Objets est considéré comme la troisième évolution de l'Internet, baptisée Web 3.0. L'Internet des Objets revêt un caractère universel pour désigner des objets connectés aux usages variés, par exemple dans le domaine industriel, agro-alimentaire, de la e-santé ou de la domotique.

Dans le cadre de l'Internet des Objets, des passerelles situées sur des points géographiquement hauts sont déployées pour le compte d'un opérateur de service, afin de créer une infrastructure réseau pour permettre à des objets communicants de communiquer. Hors opérations de maintenance, ces passerelles sont typiquement fixes et permanentes. On peut par exemple citer sur ce modèle les réseaux SigFox (marque déposée) ou ThingPark (marque déposée). Ces passerelles communiquent avec les objets communicants grâce à des systèmes de communication sans-fil moyenne ou longue portée de type LPWAN, comme par exemple la technologie LoRaWAN (marque déposée, « Long Range Wide-Area Network » en anglais), aussi connue sous le diminutif « LoRa » (marque déposée, « Long Range » en anglais) du nom de l'alliance faisant la promotion de technologies de réseaux étendus à longue portée LoRaWAN (marque déposée). Ces passerelles servent ainsi de relais entre les objets communicants et un serveur (réseau cœur), appelé LNS (pour « LoRa NetServer » en anglais, selon la terminologie de la technologie LoRaWAN) configuré pour traiter des informations remontées par les objets communicants et pour envoyer des commandes auxdits objets communicants.

De telles commandes envoyées par le serveur auxdits objets communicants concernent par exemple des ajustements de débit d'émission via un facteur d'étalement SF (« Spread Factor » en anglais) et/ou des ajustements de niveau de puissance de transmission Tx-Power, ce qui permet donc d'appliquer des politiques de débit (de données) adaptatif ADR (« Adaptive Data Rate » en anglais). Ces commandes peuvent aussi permettre de configurer lesdits objets communicants vis-à-vis d'un plan de fréquences à appliquer aux communications sans-fil de l'infrastructure réseau.

Dans de tels systèmes de communication sans-fil moyenne ou longue portée de type LPWAN, il est souhaitable de définir un plan de fréquences, c'est-à-dire de définir quelles bandes de fréquences doivent être utilisées par tels ou tels équipements desdits systèmes, de sorte à limiter les interférences lors des communications sans-fil effectuées au sein desdits systèmes. Cela permet notamment de gérer efficacement la mobilité de terminaux au sein desdits systèmes. Contrairement aux réseaux cellulaires (2G, 3G, LTE), le principe de cellules et de transfert entre cellules (« handover » en anglais), permettant de changer de cellule sans interruption des communications (voix, données), n'existent pas dans les systèmes de communication sans-fil moyenne ou longue portée de type LPWAN. Il est donc souhaitable de fournir une solution qui permette de définir et d'appliquer efficacement, et de manière automatique, un plan de fréquences dans de tels systèmes de communication sans-fil moyenne ou longue portée de type LPWAN. Il est aussi souhaitable d'assurer une mobilité efficace des terminaux dans de tels systèmes de communication sans-fil moyenne ou longue portée de type LPWAN. Le document de Lora Alliance décrit " Un aperçu technique de LoRaWan, Qu'est-ce que c'est?", 31mai 2016 (http://www.semtech.com/wireless-rf/iot/ LoRaWAN101_final.pdf).

Pour ce faire, l'invention concerne un procédé de définition et d'application d'un plan de fréquences dans un système de communication de type LPWAN comportant un serveur et une pluralité de passerelles connectées audit serveur, la pluralité de passerelles utilisant des bandes de fréquences pour effectuer des communications sans-fil avec des terminaux du système de communication. Le procédé est tel que le serveur effectue les étapes suivantes : obtenir une description d'une hiérarchie de mobilité dans laquelle des types de mobilité sont hiérarchiquement définis ; obtenir une description d'un arbre de mobilité dans lequel des zones de mobilité sont hiérarchiquement définies, chaque zone de mobilité ayant un type de mobilité en conformité avec la hiérarchie de mobilité ; obtenir des mesures de terrain associées à chaque zone de mobilité définie dans l'arbre de mobilité ; déterminer, à partir des mesures de terrain, pour chaque zone de mobilité, une information de pourcentage de temps pendant lequel les mesures de terrain montrent un niveau de signal reçu RSSI inférieur à tel ou tel seuil de niveau de signal reçu RSSI parmi un ensemble prédéfini de seuils de niveau de signal reçu RSSI. De plus, le procédé est tel que le serveur parcourt l'arbre de mobilité en itérant les étapes suivantes : sélectionner la zone de mobilité de plus haut degré hiérarchique non encore traitée ; déterminer, pour la zone de mobilité sélectionnée, une probabilité moyenne $P_m$ pour chaque bande de fréquences, à partir desdites informations de pourcentage de temps déterminées pour chaque zone de mobilité qui est une feuille de l'arbre et qui est hiérarchiquement rattachée à la zone de mobilité sélectionnée ; attribuer, pour la zone de mobilité sélectionnée, jusqu'à une quantité P de bandes de fréquences présentant les meilleures probabilités moyennes. De plus, le serveur effectue les étapes suivantes pour configurer les passerelles vis-à-vis du plan de fréquences : obtenir des descriptifs de gabarits de mobilité dans lesquels des regroupements de zones de mobilité sont effectués et dans lesquels, pour chaque regroupement, une liste de passerelles est associée à chaque regroupement pour indiquer quelles passerelles sont destinées à supporter ledit regroupement ; configurer chaque passerelle en fonction desdits descriptifs de gabarits et des bandes de fréquences attribuées aux zones de mobilité constituant lesdits regroupements. De plus, sur réception de la part d'un terminal d'une requête de connexion au système de communication, le serveur obtient un descriptif du terminal à partir d'un identifiant de terminal inclus dans ladite requête, le descriptif incluant une liste de types de mobilité auxquels ledit terminal a droit d'accès, et le serveur itère les étapes suivantes pour l'intégralité des types de mobilité auxquels ledit terminal a droit d'accès : identifier le type de mobilité de plus haut degré hiérarchique ; identifier quelles zones de mobilité correspondent audit type de mobilité de plus haut degré hiérarchique identifié ; sélectionner une zone de mobilité parmi les zones de mobilité identifiées ; et attribuer audit terminal au moins une bande de fréquences attribuée à la zone de mobilité sélectionnée. Enfin, le procédé est tel que le serveur configure ledit terminal en fonction des bandes de fréquences ainsi attribuées audit terminal. Ainsi, il est possible de définir et d'appliquer efficacement, et de manière automatique, un plan de fréquences dans un système de communication de type LPWAN, ainsi que d'assurer une mobilité efficace des terminaux dans un tel système de communication de type LPWAN.

Selon un mode de réalisation particulier, la probabilité moyenne $P_m$ est calculée de la façon suivante :

$$P_m = \frac{\sum_{k=1}^{N} \sum_{j=RSSI_d}^{RSSI_f} T_k(i,j)}{N * (RSSI_f - RSSI_d)}$$

où $RSSI_d$ est une valeur d'index correspondant à la valeur minimum de seuil de niveau de signal reçu RSSI pour laquelle une valeur de probabilité a été exprimée vis-à-vis de la zone de mobilité considérée, $RSSI_f$ est une valeur d'index correspondant à la valeur maximum de seuil de niveau de signal reçu RSSI pour laquelle une valeur de probabilité a été exprimée vis-à-vis de la zone de mobilité considérée, $N$ est la quantité de zones de mobilité considérées pour le calcul de la probabilité moyenne $P_m$, et $T_k(i,j)$ représente la probabilité associée à la bande de fréquence considérée pour la $k$-ième zone de mobilité parmi lesdites $N$ zones de mobilités pour un seuil de niveau de signal reçu RSSI représenté par une valeur d'index $j$.

Selon un mode de réalisation particulier, pour configurer ledit terminal, le serveur effectue les étapes suivantes : informer d'un premier lot de bandes de fréquences attribuées au terminal, via un message de réponse à la requête reçue ; et informer d'un second lot de bandes de fréquences attribuées au terminal, via un ou plusieurs messages complémentaires.

Selon un mode de réalisation particulier, des canaux forment des regroupements de bandes de fréquences consécutives, et le serveur attribue les bandes de fréquences sur une base canal.

Selon un mode de réalisation particulier, le serveur obtient la description de la hiérarchie de mobilité, la description de l'arbre de mobilité, les mesures de terrain, le descriptif de chaque terminal auprès d'un autre serveur externe au système de communication.

Selon un mode de réalisation particulier, le serveur vérifie que le type de mobilité de chaque zone de mobilité de l'arbre de mobilité a un degré hiérarchique inférieur au type de mobilité d'une autre zone de mobilité à laquelle ladite zone de mobilité est directement rattachée dans l'arbre de mobilité.

Selon un mode de réalisation particulier, le descriptif de chaque terminal comporte une information indiquant si le terminal est supposé être fixe, et le serveur effectue les étapes suivantes vis-à-vis du terminal ayant émis la requête reçue : déterminer la liste des bandes de fréquences éligibles audit terminal ; déterminer les bandes de fréquences de cette liste qui ont été attribuées à au moins trois passerelles parmi les passerelles ayant relayé ladite requête ; et attribuer les bandes de fréquences ainsi déterminées audit terminal EP.

Selon un mode de réalisation particulier, pour les fréquences non sélectionnées de ladite liste des bandes de fréquences éligibles, le serveur attend de recevoir d'autres trames en provenance dudit terminal pour déterminer si de nouvelles passerelles ont relayé lesdites autres trames et ainsi déterminer si d'autres bandes de fréquences de ladite liste des bandes de fréquences éligibles ont été attribuées à au moins trois passerelles parmi les passerelles ayant relayé lesdites trames.

Selon un mode de réalisation particulier, dans le cas où la quantité de passerelles réceptrices de trames ascendantes en provenance dudit terminal reste strictement inférieure à trois, le serveur émet une alerte.

L'invention concerne également un serveur configuré pour définir et appliquer un plan de fréquences dans un système de communication de type LPWAN comportant, outre ledit serveur, une pluralité de passerelles connectées audit serveur, la pluralité de passerelles utilisant des bandes de fréquences pour effectuer des communications sans-fil avec des terminaux du système de communication. Le serveur est configuré pour : obtenir une description d'une hiérarchie de mobilité dans laquelle des types de mobilité sont hiérarchiquement définis ; obtenir une description d'un arbre de mobilité dans lequel des zones de mobilité sont hiérarchiquement définies, chaque zone de mobilité ayant un type de mobilité en conformité avec la hiérarchie de mobilité ; obtenir des mesures de terrain associées à chaque zone de mobilité définie dans l'arbre de mobilité ; déterminer, à partir des mesures de terrain, pour chaque zone de mobilité, une information de pourcentage de temps pendant lequel les mesures de terrain montrent un niveau de signal reçu RSSI inférieur à tel ou tel seuil de niveau de signal reçu RSSI parmi un ensemble prédéfini de seuils de niveau de signal reçu RSSI. De plus, le serveur est configuré pour parcourir l'arbre de mobilité en itérant les étapes suivantes : sélectionner la zone de mobilité de plus haut degré hiérarchique non encore traitée ; déterminer, pour la zone de mobilité sélectionnée, une probabilité moyenne $P_m$ pour chaque bande de fréquences, à partir desdites informations de pourcentage de temps déterminées pour chaque zone de mobilité qui est une feuille de l'arbre et qui est hiérarchiquement rattachée à la zone de mobilité sélectionnée ; attribuer, pour la zone de mobilité sélectionnée, jusqu'à une quantité P de bandes de fréquences présentant les meilleures probabilités moyennes. De plus, le serveur est configuré pour effectuer les étapes suivantes pour configurer les passerelles vis-à-vis du plan de fréquences : obtenir des descriptifs de gabarits de mobilité dans lesquels des regroupements de zones de mobilité sont effectués et dans lesquels, pour chaque regroupement, une liste de passerelles est associée à chaque regroupement pour indiquer quelles passerelles sont destinées à supporter ledit regroupement ; configurer chaque passerelle en fonction desdits descriptifs de gabarits et des bandes de fréquences attribuées aux zones de mobilité constituant lesdits regroupements. De plus, sur réception de la part d'un terminal d'une requête de connexion au système de communication, le serveur est configuré pour obtenir un descriptif du terminal à partir d'un identifiant de terminal inclus dans ladite requête, le descriptif incluant une liste de types de mobilité auxquels ledit terminal a droit d'accès, et pour itérer les étapes suivantes pour l'intégralité des types de mobilité auxquels ledit terminal a droit d'accès : identifier le type de mobilité de plus haut degré hiérarchique ; identifier quelles zones de mobilité correspondent audit type de mobilité de plus haut degré hiérarchique identifié ; sélectionner une zone de mobilité parmi les zones de mobilité identifiées ; et attribuer audit terminal au moins une bande de fréquences attribuée à la zone de mobilité sélectionnée. Enfin, le serveur est configuré pour configurer ledit terminal en fonction des bandes de fréquences ainsi attribuées audit terminal.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également un medium de stockage d'informations stockant un tel programme d'ordinateur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

- la Fig. 1 illustre schématiquement un système de communication dans lequel la présente invention peut être implémentée ;
- la Fig. 2 illustre schématiquement un exemple d'architecture matérielle d'un dispositif de communication du système de communication de la Fig. 1 ;
- la Fig. 3 illustre schématiquement un exemple de hiérarchie de mobilité destinée à permettre de définir un plan de fréquences adapté au système de communication vis-à-vis de son environnement ;
- la Fig. 4 illustre schématiquement un exemple d'arbre de mobilité en application de la hiérarchie de mobilité de la Fig. 3 ;
- la Fig. 5 illustre schématiquement un algorithme, implémenté par un serveur du système de communication, de configuration dudit système de communication afin d'appliquer le plan de fréquences adapté au système de communication vis-à-vis de son environnement ;
- la Fig. 6 illustre schématiquement un algorithme, implémenté par ledit serveur du système de communication, de création d'un tableau de statistiques de probabilités versus des indications de niveau de signal reçu RSSI (« Received Signal Strength Indicator » en anglais), dans le cadre de la définition du plan de fréquences adapté au système de communication vis-à-vis de son environnement ;
- la Fig. 7 illustre schématiquement un algorithme, implémenté par ledit serveur du système de communication, de création d'une table de mobilité, représentative du plan de fréquences défini pour le système de communication ;
- la Fig. 8 illustre schématiquement un algorithme, implémenté par ledit serveur du système de communication, de configuration de passerelles du système de communication afin d'appliquer le plan de fréquences défini pour le système de communication ; et
- la Fig. 9 illustre schématiquement un algorithme, implémenté par ledit serveur du système de communication, de configuration de terminaux du système de communication afin d'appliquer le plan de fréquences défini pour le système de communication.

L'invention est plus particulièrement décrite ci-après dans un contexte d'infrastructure réseau de type LoRaWAN (marque déposée), en utilisant notamment des terminologies que l'on retrouve dans les spécifications LoRaWAN (marque déposée). Les principes et implémentations décrits ci-après s'appliquent cependant, de manière plus générale, à un contexte d'infrastructure réseau de type LPWAN.

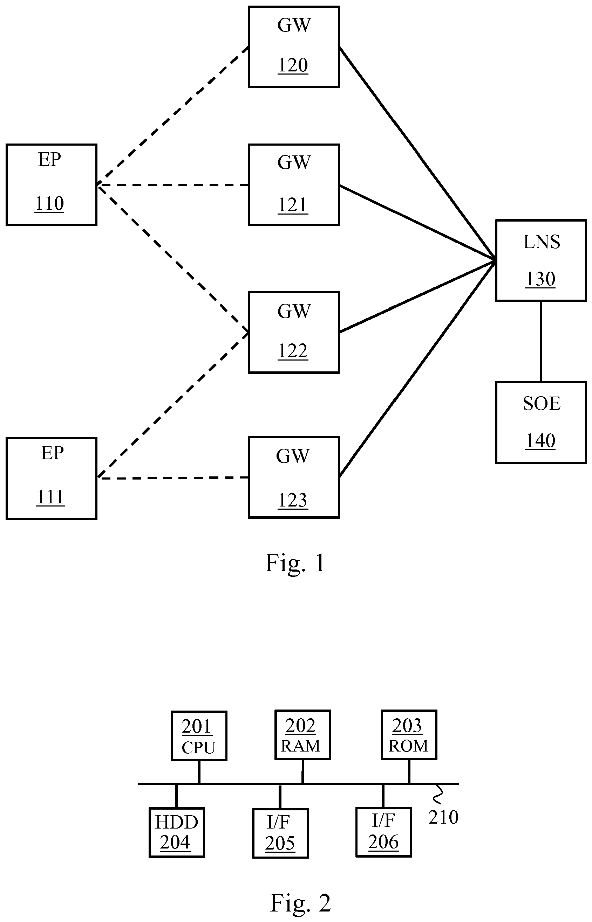

La Fig. 1 illustre schématiquement un système de communication dans lequel la présente invention peut être implémentée.

Le système de communication comporte une pluralité de passerelles GW 120, 121, 122, 123. Les passerelles GW 120, 121, 122, 123 disposent de liens de communication respectifs avec un serveur LNS 130 auquel lesdites passerelles GW sont rattachées. Selon un mode de réalisation particulier, chaque passerelle GW 120, 121, 122, 123 intègre une fonction d'accès à l'Internet et le lien de communication entre ladite passerelle résidentielle avec le serveur LNS 130 repose sur le protocole IP (« Internet Protocol » en anglais, tel que défini dans le document normatif RFC 791).

Dans le système de communication, des messages doivent être remontés jusqu'au serveur LNS 130 sous forme de trames depuis chaque dispositif terminal EP (« End-Point » en anglais) 110, 111 d'un ensemble de dispositifs terminaux dudit système de communication. Ledit serveur LNS 130 a un rôle de contrôle et de collecte d'informations disponibles auprès des dispositifs terminaux EP 110, 111, et les passerelles GW 120, 121, 122, 123 ont un rôle de relais entre les dispositifs terminaux EP 110, 111 et le serveur LNS 130. Des messages, notamment de commande, peuvent aussi être transmis sous forme de trames depuis le serveur LNS 130 jusqu'aux dispositifs terminaux EP 110, 111 via les passerelles de collecte GW 120, 121, 122, 123. De telles commandes envoyées par le serveur LNS 130 auxdits dispositifs terminaux EP 110, 111 permettent plus particulièrement, dans le cadre de la présente invention, de configurer les dispositifs terminaux EP 110, 111 vis-à-vis d'un plan de fréquences à faire appliquer aux communications sans-fil dans le système de communication.

Pour permettre de remplir ce rôle de relais, chaque passerelle GW 120, 121, 122, 123 dispose d'au moins une interface radio permettant à ladite passerelle de collecte de communiquer avec au moins un dispositif terminal EP 110, 111 en s'appuyant sur un réseau de communication sans-fil, et préférentiellement selon une technologie de communication de type LPWAN. Ladite interface radio est par exemple de type LoRa (marque déposée) permettant ainsi d'implémenter, au sein du système de communication, un protocole de transmission de données de type LoRaWAN (marque déposée). Ladite interface radio est telle qu'un dispositif terminal EP peut être à portée de communication par voie radio d'une pluralité de passerelles GW, selon la position géographique dudit dispositif terminal EP par rapport aux passerelles GW 120, 121, 122, 123 et des conditions de transmission par voie radio dans l'environnement dudit dispositif terminal EP et des passerelles GW 120, 121, 122, 123. C'est le cas par exemple du dispositif terminal EP 110 sur la Fig. 1, qui est à portée de communication par voie radio des passerelles GW 120, 121 et 122. Le dispositif terminal EP 111 sur la Fig. 1 est, quant à lui, à portée de communication par voie radio des passerelles GW 122 et 123.

Le système de communication est préférentiellement connecté, via le serveur LNS 130, à un serveur SOE (« Service Operator Equipment » en anglais) 140, afin de permettre au serveur LNS 130 d'obtenir des informations et descriptifs de la part de l'opérateur de service à la disposition duquel le système de communication a été mis en place. Les communications entre le serveur LNS 130 et le serveur SOE 140 s'appuient sur un protocole de communication adapté pour permettre au serveur LNS 130 d'obtenir lesdites informations et lesdits descriptifs, comme par exemple le protocole TCP (« Transmission Control Protocol » en anglais, tel que défini dans le document normatif RFC 793). En variante de réalisation, le serveur LNS 130 est configuré pour obtenir lesdites informations et lesdits descriptifs via une interface homme-machine implémentée par ledit serveur LNS 130.

La **Fig. 2** illustre schématiquement un exemple d'architecture matérielle d'un dispositif de communication du système de communication de la Fig. 1. Chaque dispositif terminal EP 110, 111 et/ou chaque passerelle GW 120, 121, 122, 123 et/ou le serveur LNS 130 et/ou le serveur SOE 140 peuvent être construits sur la base d'une telle architecture matérielle.

Le dispositif de communication comporte, reliés par un bus de communication 210 : un processeur ou CPU (« Central Processing Unit » en anglais) 201 ; une mémoire vive RAM (« Random Access Memory » en anglais) 202 ; une mémoire morte ROM (« Read Only Memory » en anglais) 203 ; une unité de stockage ou un lecteur de support de stockage, tel qu'un lecteur de cartes SD (« Secure Digital » en anglais) ou un disque dur HDD (« Hard Disk Drive » en anglais) 204 ; une interface de communication I/F 205, et éventuellement une autre interface de communication I/F 206.

Lorsque le dispositif de communication de la Fig. 2 représente un dispositif terminal EP du système de communication, l'interface de communication I/F 205 est configurée pour permettre audit dispositif terminal EP de communiquer avec une ou plusieurs passerelles GW du système de communication.

Lorsque le dispositif de communication de la Fig. 2 représente une passerelle GW du système de communication, l'interface de communication I/F 205 est configurée pour permettre à ladite passerelle GW de communiquer avec des dispositifs terminaux EP du système de communication, et l'autre interface de communication I/F 206 est configurée pour permettre à ladite passerelle GW de communiquer avec le serveur LNS 130.

Lorsque le dispositif de communication de la Fig. 2 représente le serveur LNS 130, l'interface de communication I/F 205 est configurée pour permettre audit serveur LNS 130 de communiquer avec les passerelles GW du système de communication. Dans un mode de réalisation particulier, l'autre interface de communication I/F 206 est configurée pour permettre audit serveur LNS 130 de communiquer avec le serveur SOE 140.

Lorsque le dispositif de communication de la Fig. 2 représente le serveur SOE 140, l'interface de communication I/F 205 est configurée pour permettre audit serveur SOE 140 de communiquer avec le serveur LNS 130.

Le processeur 201 est capable d'exécuter des instructions chargées dans la RAM 202 à partir de la ROM 203, d'une mémoire externe, d'un support de stockage, ou d'un réseau de communication. Lorsque le dispositif de communication est mis sous tension, le processeur 201 est capable de lire de la RAM 202 des instructions et de les exécuter. Ces instructions forment un programme d'ordinateur causant l'implémentation, par le processeur 201, de tout ou partie des algorithmes et étapes décrits ici en relation avec le dispositif de communication en question.

Ainsi, tout ou partie des algorithmes et étapes décrits ici peut être implémenté sous forme logicielle par exécution d'un ensemble d'instructions par une machine programmable, tel qu'un DSP (« Digital Signal Processor » en anglais) ou un microcontrôleur. Tout ou partie des algorithmes et étapes décrits ici peut aussi être implémenté sous forme matérielle par une machine ou un composant dédié, tel qu'un FPGA (« Field-Programmable Gate Array » en anglais) ou un ASIC (« Application-Specific Integrated Circuit » en anglais).

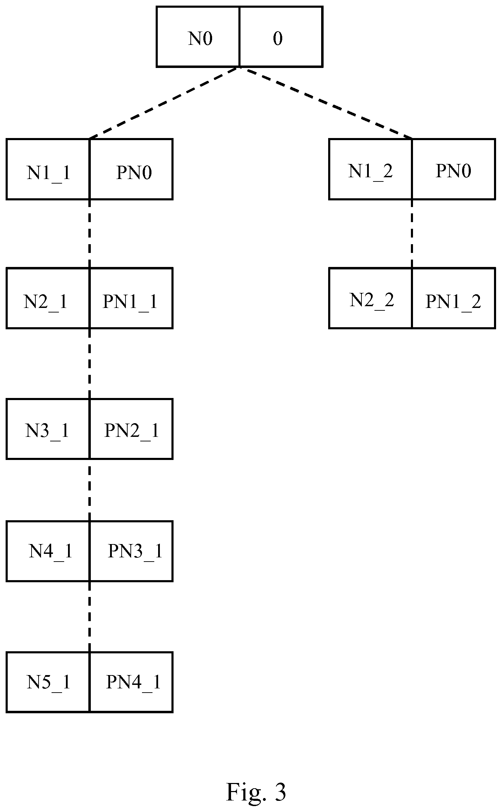

La **Fig. 3** illustre schématiquement un exemple de hiérarchie de mobilité destinée à permettre de définir un plan de fréquences adapté au système de communication vis-à-vis de son environnement.

Le serveur LNS 130 permet à l'opérateur de service de définir une hiérarchie de mobilité consistant en un ensemble hiérarchisé de types de mobilité (MobilityType). Cette définition de la hiérarchie de mobilité est ainsi fournie par le serveur SOE 140 au serveur LNS 130, ou est fournie au serveur LNS 130 par le biais de son interface homme-machine. L'ensemble hiérarchisé de types de mobilité correspond aux différents types de mobilité géographique que les terminaux EP du système de communication sont autorisés à avoir : local, à la dimension d'une ville, régional, national,... ou toute autre hiérarchie de types de couverture géographique. L'ensemble hiérarchisé de types de mobilité est donc un ensemble de types de zones de couverture réseau hiérarchisés selon la taille de leurs couvertures réseau respectives. La convention de nommage des types de mobilité et l'interprétation de la hiérarchie sont à la charge de l'opérateur de service.

La hiérarchie de mobilité est donc un ensemble hiérarchisé de types de mobilité (MobilityType), dont un exemple de réalisation est illustré par la Fig. 3 sous forme d'arbre de nœuds interconnectés. La racine de la hiérarchie est représentée tout en haut de la Fig. 3, et représente le plus haut degré hiérarchique. Chaque nœud de l'arbre comporte au moins deux éléments : un nom de type de mobilité et un pointeur vers le nœud parent dans la hiérarchie. La racine correspond à un type de mobilité génériquement labellisé N0 sur la Fig. 3. Par exemple, le type de la racine est nommé « Norme ». La racine n'ayant, par définition, pas de nœud parent, le pointeur associé à la racine est sans signification. Par exemple, ce pointeur est fixé à une valeur prédéfinie (e.g. « 0 ») ou pointe sur la racine elle-même. Deux types de mobilité, génériquement labellisés N1_1 et N1_2 sur la Fig. 3, sont hiérarchiquement directement attachés à la racine. Par exemple, le type génériquement labellisé N1_1 est nommé « Public » et le type génériquement labellisé N1_2 est nommé « Corporate ». Les pointeurs des types de mobilité génériquement labellisés N1_1 et N1_2 sur la Fig. 3 pointent sur la racine. Chacun d'eux est ainsi labellisé PN0 sur la Fig. 3. Un unique type de mobilité, génériquement labellisé N2_2 sur la Fig. 3, est hiérarchiquement directement attaché au type de mobilité génériquement labellisé N1_2 sur la Fig. 3. Par exemple, le type de mobilité génériquement labellisé N2_2 sur la Fig. 3 est nommé « Service Postal ». Le pointeur du type de mobilité génériquement labellisé N2_2 sur la Fig. 3 pointe sur le type de mobilité génériquement labellisé N1_2 sur la Fig. 3, et est ainsi labellisé PN1_2 sur la Fig. 3. Un unique type de mobilité, génériquement labellisé N2_1 sur la Fig. 3, est hiérarchiquement directement attaché au type de mobilité génériquement labellisé N1_1 sur la Fig. 3. Par exemple, le type de mobilité génériquement labellisé N2_1 sur la Fig. 3 est nommé « National ». Le pointeur du type de mobilité génériquement labellisé N2_1 sur la Fig. 3 pointe sur le type de mobilité génériquement labellisé N1_1 sur la Fig. 3, et est ainsi labellisé PN1_1 sur la Fig. 3. Un unique type de mobilité, génériquement labellisé N3_1 sur la Fig. 3, est hiérarchiquement directement attaché au type de mobilité génériquement labellisé N2_1 sur la Fig. 3. Par exemple, le type de mobilité génériquement labellisé N3_1 sur la Fig. 3 est nommé « Agglomération ». Le pointeur du type de mobilité génériquement labellisé N3_1 sur la Fig. 3 pointe sur le type de mobilité génériquement labellisé N2_1 sur la Fig. 3, et est ainsi labellisé PN2_1 sur la Fig. 3. Un unique type de mobilité, génériquement labellisé N4_1 sur la Fig. 3, est hiérarchiquement directement attaché au type de mobilité génériquement labellisé N3_1 sur la Fig. 3. Par exemple, le type de mobilité génériquement labellisé N4_1 sur la Fig. 3 est nommé « Ville ». Le pointeur du type de mobilité génériquement labellisé N4_1 sur la Fig. 3 pointe sur le type de mobilité génériquement labellisé N3_1 sur la Fig. 3, et est ainsi labellisé PN3_1 sur la Fig. 3. Enfin, un unique type de mobilité, génériquement labellisé N5_1 sur la Fig. 3, est hiérarchiquement directement attaché au type de mobilité génériquement labellisé N4_1 sur la Fig. 3. Par exemple, le type de mobilité génériquement labellisé N5_1 sur la Fig. 3 est nommé « Local ». Le pointeur du type de mobilité génériquement labellisé N5_1 sur la Fig. 3 pointe sur le type de mobilité génériquement labellisé N5_1 sur la Fig. 3, et est ainsi labellisé PN4_1 sur la Fig. 3.

Chaque nœud de l'arbre peut comporter un ou plusieurs éléments supplémentaires, comme par exemple un pointeur vers chacun de ses éventuels nœuds enfants dans la hiérarchie de mobilité.

Dans le cas où le serveur LNS 130 doit gérer plusieurs hiérarchies, un tel arbre est fourni au serveur LNS 130 pour chacune desdites hiérarchies et peuvent ainsi avoir des structures différentes, des conventions de nommages différentes, ainsi que des interprétations différentes. Un identifiant de hiérarchie est alors utilisé pour distinguer, les unes par rapport aux autres, les hiérarchies ainsi définies.

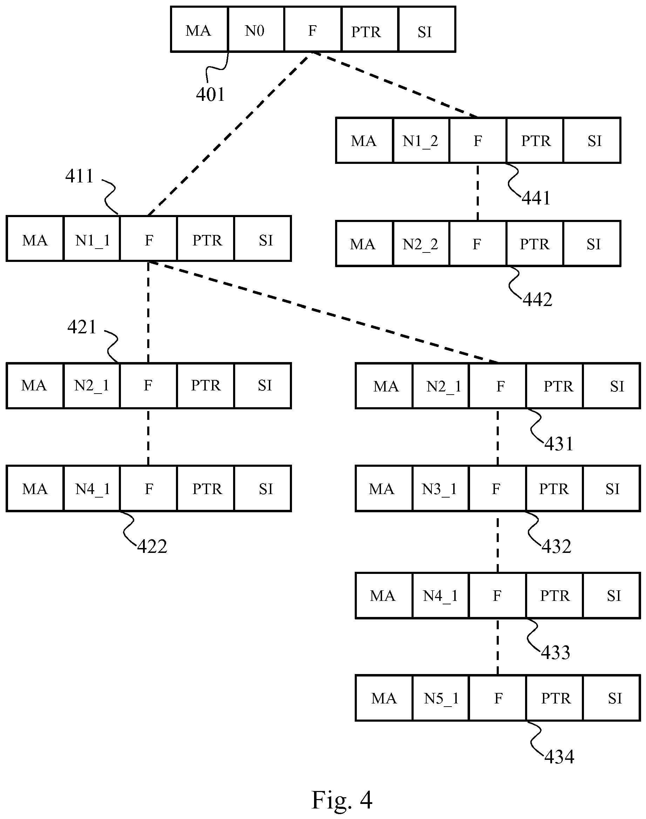

La **Fig. 4** illustre schématiquement un exemple d'arbre de mobilité en application de la hiérarchie de mobilité telle que précédemment décrite en relation avec la Fig. 3.

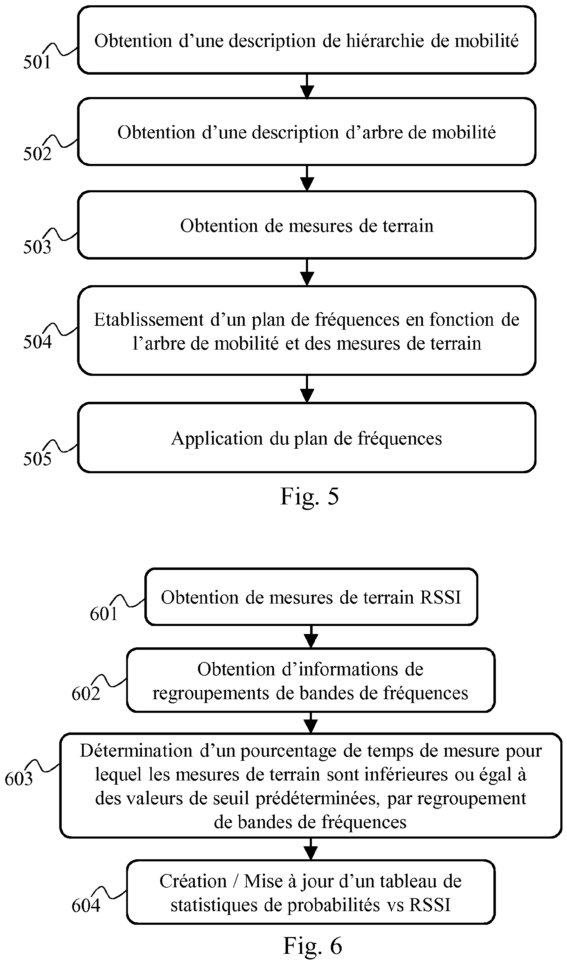

Un arbre de mobilité est une instance d'une hiérarchie de mobilité. Cet arbre correspond à une description de couverture géographique des communications sans-fil du système de communication pour un service donné, dans lequel chaque nœud de l'arbre est une instance d'un type de mobilité défini dans ladite hiérarchie de mobilité et dans lequel chaque nœud de l'arbre est associé à une zone de mobilité (MobilityArea). Chaque zone de mobilité est associée à un type de mobilité (MobilityType) avec un degré hiérarchique inférieur à celui associé à son nœud parent, ou zone de mobilité parente. Chaque nœud de l'arbre comporte au moins quatre éléments : un nom MA de zone de mobilité, le type de mobilité de ladite zone de mobilité, un pointeur PTR vers la zone de mobilité parente, et au moins une bande de fréquences F associée à ladite zone de mobilité. La ou les bandes de fréquences F associées à ladite zone de mobilité sont déterminées comme décrit ci-après en relation avec les Figs. 6 à 8.

Un exemple d'arbre de mobilité est représenté sur la Fig. 4, en s'appuyant sur l'exemple de hiérarchie de mobilité représenté sur la Fig. 3. L'arbre de mobilité comporte alors une racine 401 qui est une instance de type de mobilité « Norme ». Par exemple, la racine 401 représente une zone de mobilité MA dénommée « LoRa ». L'arbre de mobilité comporte aussi deux nœuds 411 et 441 directement attachés à la racine 401. Le nœud 411 est une instance de type de mobilité « Public », et le nœud 441 est une instance de type de mobilité « Corporate ». Par exemple, le nœud 411 représente une zone de mobilité MA dénommée « Public », et le nœud 441 représente une zone de mobilité MA dénommée « Corporate ». L'arbre de mobilité comporte aussi deux nœuds 421 et 431 directement attachés au nœud 411. Les nœuds 421 et 431 sont des instances de type de mobilité « National ». Par exemple, le nœud 421 représente une zone de mobilité MA dénommée « Tunisie », et le nœud 431 représente une zone de mobilité MA dénommée « France ». Un unique nœud 422 est directement attaché au nœud 421. Le nœud 422 est une instance de type de mobilité « Ville ». Par exemple, le nœud 422 représente une zone de mobilité MA dénommée « Tunis ». On notera donc que chaque zone de mobilité est associée à un type de mobilité (MobilityType) de degré hiérarchique inférieur à celui associé à sa zone de mobilité parente dans l'arbre de mobilité, sans qu'il ne soit nécessaire que ladite zone de mobilité soit associée à un type de mobilité (MobilityType) de degré hiérarchique immédiatement inférieur à celui associé à sa zone de mobilité parente dans la hiérarchie de mobilité considérée. En d'autres termes, des sauts de degré hiérarchique peuvent être effectués pour définir l'arbre de mobilité, par rapport à la définition de la hiérarchie de mobilité dont l'arbre de mobilité est une instance. Un unique nœud 432 est directement attaché au nœud 431. Le nœud 432 est une instance de type de mobilité « Agglomération ». Par exemple, le nœud 432 représente une zone de mobilité MA dénommée « Agglomération Parisienne ». Un unique nœud 433 est directement attaché au nœud 432. Le nœud 433 est une instance de type de mobilité « Ville ». Par exemple, le nœud 433 représente une zone de mobilité MA dénommée « Rueil ». Un unique nœud 434 est directement attaché au nœud 433. Le nœud 434 est une instance de type de mobilité « Local ». Par exemple, le nœud 434 représente une zone de mobilité MA dénommée « Sagemcom ». Enfin, un unique nœud 442 est directement attaché au nœud 441. Le nœud 442 est une instance de type de mobilité « Service Postal ». Par exemple, le nœud 442 représente une zone de mobilité MA dénommée « Garages Automobiles ».

Chaque nœud de l'arbre peut comporter un ou plusieurs éléments supplémentaires SI, comme par exemple un pointeur vers chacun de ses éventuels nœuds enfants.

Dans le cas où le serveur LNS 130 doit gérer plusieurs hiérarchies, un tel arbre est fourni au serveur LNS 130 en association avec un identifiant de hiérarchie affecté à la hiérarchie de mobilité à laquelle ledit arbre de mobilité se réfère. Plusieurs arbres de mobilité peuvent être définis comme instances distinctes d'une même hiérarchie de mobilité. Un identifiant d'arbre de mobilité est alors utilisé pour distinguer, les uns par rapport aux autres, les arbres de mobilité ainsi définis.

La **Fig. 5** illustre schématiquement un algorithme, implémenté par le serveur LNS 130, de configuration du système de communication afin d'appliquer un plan de fréquences adapté au système de communication vis-à-vis de son environnement.

Dans une étape 501, le serveur LNS 130 obtient une description de hiérarchie de mobilité, telle que présentée ci-dessus en relation avec la Fig. 3.

Dans une étape 502, le serveur LNS 130 obtient une description d'un arbre de mobilité, telle que présentée ci-dessus en relation avec la Fig. 4. Préférentiellement, le serveur LNS 130 vérifie la conformité de l'arbre de mobilité vis-à-vis de la hiérarchie de mobilité.

Dans une étape 503, le serveur LNS 130 obtient des mesures de terrain associées à chaque zone de mobilité définie dans l'arbre de mobilité. Cet aspect est détaillé par la suite en relation avec la Fig. 6.

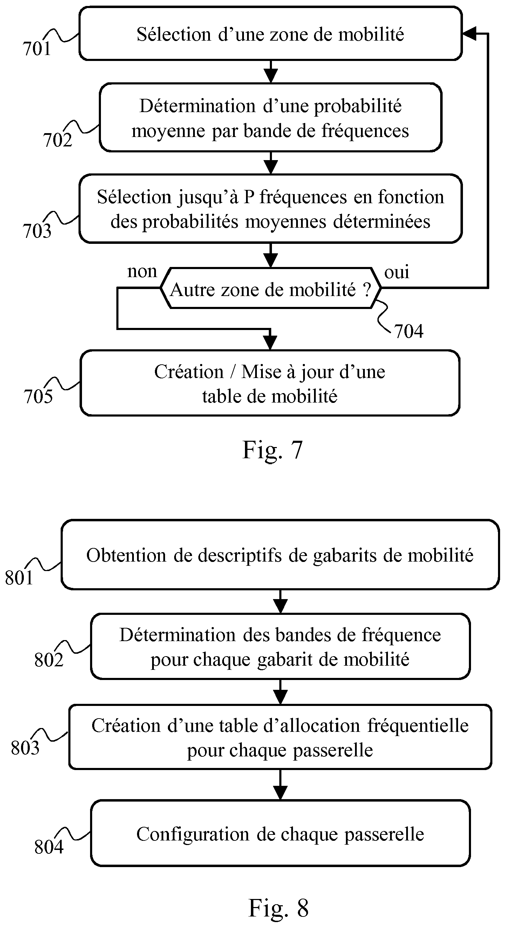

Dans une étape 504, le serveur LNS 130 établit un plan de fréquence à appliquer au sein du système de communication, à partir des mesures de terrain et de l'arbre de mobilité, afin d'améliorer les performances de communication du système de communication vis-à-vis de son environnement. Cet aspect est détaillé par la suite en relation avec la Fig. 7.

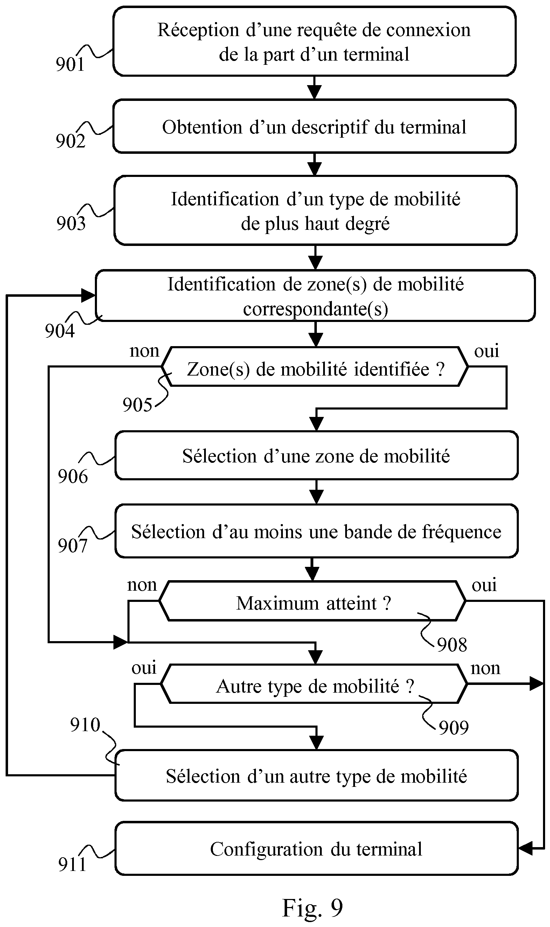

Dans une étape 505, le serveur LNS 130 instruit les passerelles GW et les terminaux EP du système de communication d'appliquer le plan de fréquences défini à l'étape 504. Cet aspect est détaillé par la suite en relation avec les Figs. 8 et 9.

La **Fig. 6** illustre schématiquement un algorithme, implémenté par le serveur LNS 130, de création d'un tableau de statistiques de probabilités versus des indications de niveau de signal reçu RSSI, dans le cadre de la définition du plan de fréquences adapté au système de communication vis-à-vis de son environnement.

Dans une étape 601, le serveur LNS 130 obtient des mesures de terrain, pour chaque zone de mobilité (MobilityArea) qui est une feuille (point de terminaison de l'arbre par rapport à la racine de l'arbre) dans l'arbre de mobilité obtenu par le serveur LNS 130 à l'étape 501. Les mesures de terrain sont fournies au serveur LNS 130 par le serveur SOE 140 ou par saisie via son interface homme-machine.

Le serveur LNS 130 manipule les mesures de terrain obtenues, de sorte à obtenir, par bande de fréquence ou par canal utilisable pour les communications sans-fil entre les passerelles GW et les terminaux EP, une information de pourcentage de temps pendant lequel les mesures de terrain montrent un niveau de signal reçu inférieur à tel ou tel seuil de niveau de signal reçu RSSI parmi un ensemble prédéfini de seuils de niveau de signal reçu RSSI. Cet aspect est détaillé ci-après en regard du reste de l'algorithme de la Fig. 6.

Les mesures de terrain sont acquises de la manière suivante. L'objectif est de connaître, avec la meilleure précision possible, le bruit présent dans les différentes bandes de fréquences dans lesquelles le système de communication est autorisé à effectuer des communications, afin de pouvoir déterminer un plan de fréquences adapté au système de communication vis-à-vis de son environnement.

Le principe de la mesure consiste, pour chaque zone de mobilité concernée, à connecter un récepteur radio de type analyseur de spectre sur une antenne d'un point haut de ladite zone de mobilité et à enregistrer au fil du temps des échantillons de bruit dans les différentes bandes de fréquences. Par exemple, le système de communication est autorisé à effectuer des communications dans des bandes de fréquences de 25 kHz entre 863 MHz à 870 MHz. Le récepteur radio enregistre des variations du niveau reçu RSSI pendant une durée prédéfinie par bande de fréquences, et procède ainsi successivement pour l'ensemble des bandes de fréquences dans lesquelles le système de communication est autorisé à effectuer des communications. Cette procédure peut être itérée sur plusieurs cycles, les mesures acquises étant alors combinées selon une règle prédéfinie (addition, moyenne, max, min,...) à celles précédemment acquises. Plus la quantité de cycles effectués est grande, plus la précision sur les bruits statistiquement présents dans les bandes de fréquence considérées est grande. Les mesures peuvent ensuite être regroupées par canal de communication, si de tels canaux de communication regroupant plusieurs bandes de fréquences consécutives sont définis pour effectuer les communications sans-fil du système de communication. Par exemple, les mesures effectuées sont regroupées par canal de communication de 125 kHz de largeur, regroupant ainsi chacun cinq bandes de fréquences consécutives de 25 kHz. Ce regroupement peut aussi être effectué par le serveur LNS 130, comme décrit ci-après en relation avec une étape 602.

Ainsi, les mesures effectuées peuvent être présentées sous la forme d'un tableau de mesures ayant en ordonnées les bandes de fréquences ou canaux considérés et en abscisses des valeurs prédéfinies (seuils) de niveau reçu RSSI. Chaque cellule du tableau comporte alors, pour la bande de fréquence ou canal correspondant à ladite cellule, une information de temps pendant lequel les mesures effectuées montrent un niveau de signal reçu RSSI inférieur ou égal à la valeur prédéfinie (seuil) de niveau reçu RSSI correspondant à ladite cellule. A chaque ligne du tableau est associée une information de temps T pendant lequel les mesures ont été effectuées pour la bande de fréquences ou le canal correspondant à ladite ligne.

Dans l'étape 602, pour effectuer au besoin des regroupements de mesures par canal à partir de mesures obtenues par bande de fréquences (chaque canal étant un regroupement prédéfini de plusieurs bandes de fréquences consécutives), le serveur LNS 130 ajoute entre elles les valeurs contenues dans les cellules concernées du tableau de mesures de terrain. A chaque canal est alors associée la somme des informations de temps T qui étaient précédemment associées aux bandes de fréquences constituant ledit canal.

A partir des mesures effectuées, il est possible de déterminer par bande de fréquences ou par canal, le pourcentage du temps pendant lequel il n'y a statistiquement pas de bruit supérieur à une valeur donnée (seuil) de signal reçu RSSI. Pour cela, dans une étape 603, le serveur LNS 130 détermine, pour chaque bande de fréquence ou canal en question, le temps des mesures de terrain qui ont donné un niveau de signal reçu RSSI inférieur à la valeur prédéfinie (seuil) de signal reçu RSSI considérée, et ce, vis-à-vis de chaque valeur prédéfinie (seuil) de signal reçu RSSI. Le serveur LNS 130 divise ensuite ce temps par la quantité d'unités de temps pendant lesquelles les mesures ont été effectuées pour la bande de fréquence ou le canal en question, ce qui donne, par valeur de seuil RSSI, le pourcentage de temps recherché.

Dans une étape 604, le serveur LNS 130 crée, ou met à jour, un tableau de statistiques de probabilités versus niveau de signal reçu RSSI. Ce tableau de statistiques contient alors en ordonnées les bandes de fréquences ou canaux considérés et en abscisses les valeurs prédéfinies (seuils) de niveau reçu RSSI. Chaque cellule du tableau comporte alors, pour la bande de fréquence ou canal correspondant à ladite cellule, l'information de pourcentage de temps pendant lequel les mesures de terrain ont donné un niveau de signal reçu RSSI inférieur ou égal à la valeur prédéfinie (seuil) de niveau de signal reçu RSSI correspondant à ladite cellule. Le tableau de statistiques ainsi créé est ensuite utilisé par le serveur LNS 130, comme détaillé ci-dessous en relation avec la Fig. 7. Dans un mode de réalisation en variante, le serveur LNS 130 reçoit du serveur SOE 140, ou via son interface homme-machine, directement le tableau de statistiques de probabilités versus niveau de signal reçu RSSI.

La **Fig. 7** illustre schématiquement un algorithme, implémenté par le serveur LNS 130, de création d'une table de mobilité représentative du plan de fréquences défini pour le système de communication.

Dans une étape 701, le serveur LNS 130 sélectionne la zone de mobilité de plus haut degré hiérarchique non encore traitée dans le cadre de l'exécution courante de l'algorithme de la Fig. 7. Lorsqu'il existe plusieurs zones de mobilité de même degré hiérarchique pouvant être sélectionnées par le serveur LNS 130 dans l'étape 701, le serveur LNS 130 applique une règle prédéfinie pour sélectionner une zone de mobilité parmi les zones de mobilité de même degré hiérarchique pouvant être sélectionnées par le serveur LNS 130 dans l'étape 701. A la première itération en séquence de l'étape 701 dans le cadre de l'exécution courante de l'algorithme de la Fig. 7, le serveur LNS 130 sélectionne la zone de mobilité racine de l'arbre de mobilité.

Dans une étape 702, le serveur LNS 130 détermine, pour la zone de mobilité sélectionnée à l'étape 701, une probabilité moyenne $P_m$ pour chaque bande de fréquences ou canal, à partir du tableau de statistiques (de probabilités versus niveau de signal reçu RSSI) obtenu vis-à-vis de chaque zone de mobilité qui se trouve être une feuille de l'arbre de mobilité et qui est hiérarchiquement (indirectement ou directement) rattachée à la zone de mobilité sélectionnée à l'étape 701. Cette probabilité moyenne $P_m$ est représentative de la probabilité qu'il n'y ait pas de bruit menant à une valeur de RSSI donnée sur la bande de fréquences ou le canal en question.

La probabilité moyenne $P_m$ susmentionnée est calculée de la façon suivante :

$$P_m = \frac{\sum_{k=1}^{N} \sum_{j=RSSI_d}^{RSSI_f} T_k(i,j)}{N * (RSSI_f - RSSI_d)}$$

où $RSSI_d$ est une valeur d'index correspondant à la valeur minimum de seuil RSSI pour laquelle une valeur de probabilité a été exprimée dans le tableau de probabilité considéré, $RSSI_f$ est une valeur d'index correspondant à la valeur maximum de seuil RSSI pour laquelle une valeur de probabilité a été exprimée dans le tableau de probabilité considéré, N est la quantité de tableaux de statistiques de probabilités considérés pour le calcul de la probabilité moyenne $P_m$, et $T_k(i,j)$ représente la probabilité associée à la bande de fréquence considérée ou au canal considéré dans le *k-ième* tableau de probabilité (parmi lesdits tableaux considérés) pour un seuil RSSI représenté par une valeur d'index *j*.

Dans une étape 703, le serveur LNS 130 sélectionne jusqu'à une quantité prédéfinie P (P ≥ 1) de bandes de fréquences ou canaux parmi les bandes de fréquences ou canaux utilisables par le système de communication pour effectuer les communications sans-fil. Les bandes de fréquences ou canaux sélectionnés par le serveur LNS 130 sont les bandes de fréquences ou canaux présentant les meilleures probabilités moyennes (valeurs les plus élevées) telles que calculées à l'étape 702, pour peu que les bandes de fréquences ou canaux en question n'aient pas déjà été attribués à la racine ou à une zone de mobilité qui est un intermédiaire dans l'arbre de mobilité entre la racine et la zone de mobilité sélectionnée à l'étape 701. Si moins de P bandes de fréquences ou canaux subsistent après avoir retiré les bandes de fréquences ou canaux attribués à la racine ou à une zone de mobilité qui est un intermédiaire dans l'arbre de mobilité entre la racine et la zone de mobilité sélectionnée à l'étape 701, alors le serveur LNS 130 sélectionne ces bandes de fréquences ou canaux qui subsistent. Si toutes les fréquences ont été sélectionnées et qu'il reste encore des zones de mobilités à traiter, alors le serveur LNS 130 n'alloue pas de lui-même de fréquences à ces zones de mobilité. Il s'agit d'un cas de mauvais dimensionnement du système de communication par l'opérateur de service. Par conséquent, le serveur LNS 130 envoie une alarme au serveur SOE 140 afin que l'opérateur de service puisse définir en retour une politique d'allocation de fréquences en conséquence, comme par exemple forcer l'attribution des P bandes de fréquences ou canaux ayant les meilleures probabilités moyennes ou annuler la mise en place, en cours, du plan de fréquences. Si au moins P bandes de fréquences ou canaux subsistent après avoir retiré les bandes de fréquences ou canaux attribués à la racine ou à une zone de mobilité qui est un intermédiaire dans l'arbre de mobilité entre la racine et la zone de mobilité sélectionnée à l'étape 701, le serveur LNS 130 sélectionne les P bandes de fréquences ou canaux présentant les meilleures probabilités moyennes telles que calculées à l'étape 702. Les bandes de fréquences ou canaux ainsi sélectionnés par le serveur LNS 130 sont alors attribués à la zone de mobilité sélectionnée à l'étape 701.

La quantité P peut être un paramètre par défaut du serveur LNS 130 ; la quantité P peut en variante être un paramètre fourni par le serveur SOE 140 au serveur LNS 130. A noter que le paramètre P est potentiellement différent d'une zone de mobilité à une autre.

Dans une étape 704, le serveur LNS 130 vérifie si au moins une autre zone de mobilité de l'arbre de mobilité doit être considérée. Le serveur LNS 130 est supposé parcourir l'arbre de la racine de l'arbre vers chaque feuille de l'arbre, jusqu'à ce que l'arbre soit intégralement parcouru. Si au moins une moins une autre zone de mobilité doit être considérée, l'étape 701 est réitérée ; sinon, une étape 705 est effectuée.

Dans l'étape 705, le serveur LNS 130 crée, ou met à jour, une table de mobilité associée à l'arbre de mobilité en question. La table de mobilité fournit, pour chaque zone de mobilité de l'arbre de mobilité, une ou plusieurs bandes de fréquences ou canaux qui ont ainsi été attribués à ladite zone de mobilité. La table de mobilité peut contenir des informations complémentaires, comme par exemple un rappel du type de mobilité caractérisant la zone de mobilité en question, un rappel de la zone de mobilité parente dans l'arbre de mobilité,...

La **Fig. 8** illustre schématiquement un algorithme, implémenté par le serveur LNS 130, de configuration des passerelles GW afin d'appliquer le plan de fréquences tel que défini par exécution de l'algorithme de la Fig. 7.

Dans une étape 801, le serveur LNS 130 obtient des descriptifs de gabarits de mobilité qui correspondent respectivement à des ensembles de zones de mobilité. En effet, afin de couvrir le plus de zones de mobilité possibles, chaque passerelle GW supporte préférentiellement plusieurs zones de mobilité, ce qui se traduit par le fait de gérer des bandes de fréquences ou canaux attribués à plusieurs zones de mobilité. Pour y parvenir, le serveur LNS 130 obtient ces gabarits de mobilité auprès du serveur SOE 140 ou par saisie via son interface homme-machine.

Pour avoir de la cohérence au niveau de la couverture radio, il faut que toutes les bandes de fréquences (ou canaux) ou une même partie de ces bandes de fréquences (ou canaux) attribués à chaque zone de mobilité soient configurées dans toutes les passerelles GW auxquelles la zone de mobilité correspond. En effet, les terminaux EP supposés être actifs dans une même zone de mobilité doivent être configurés de sorte à communiquer via des bandes de fréquences ou canaux attribués à cette zone de mobilité. Si un terminal EP est configuré avec une bande de fréquences ou un canal qui n'est pas configuré dans une passerelle GW environnante susceptible de recevoir les trames ascendantes (« uplink frames » en anglais) émises par ledit terminal, alors ces trames ascendantes ne sont pas reçues par cette passerelle GW. Par conséquent, une mauvaise configuration vis-à-vis du plan de fréquences augmente inutilement le taux de pertes de trames (« Frame Error Rate » en anglais).

Il est en outre envisageable de découper le plan de fréquences d'une passerelle GW en plusieurs hiérarchies. Par exemple, une quantité de canaux pourrait être affectée à une première hiérarchie de mobilité et une quantité d'autres canaux pourrait être affectée à une seconde hiérarchie de mobilité. Il faut garder à l'esprit qu'une mauvaise configuration pourrait engendrer des doublons de bandes de fréquences, ce qui perturberait la mise en place de ces hiérarchies en parallèle.

Chaque descriptif de gabarit comporte les informations suivantes : un identifiant de gabarit, une liste des zones de mobilité contenues dans la zone de couverture radio associée au gabarit, et une liste des passerelles GW qui doivent permettre de réaliser ladite zone de couverture radio. Lorsque le système de communication supporte plusieurs hiérarchies de mobilité en parallèle, chaque gabarit comporte en outre un identifiant de la hiérarchie de mobilité à laquelle ledit gabarit réfère.

Dans une étape 802, le serveur LNS 130 détermine, à partir de la table de mobilité obtenue par exécution de l'algorithme de la Fig. 7 et des descriptifs de gabarits obtenus à l'étape 801, la liste des bandes de fréquences ou canaux attribués à chaque gabarit. Cette liste correspond à l'agrégation des bandes de fréquences ou canaux attribués aux zones de mobilité constituant le gabarit en question. Le serveur LNS 130 peut mettre à jour les descriptifs de gabarits avec la liste des bandes de fréquences respectivement attribuées auxdits gabarits.

Dans une étape 803, le serveur LNS 130 crée une table d'allocation fréquentielle GWT-F pour chaque passerelle GW, à partir des descriptifs des gabarits. Chaque descriptif de gabarit donne la liste de passerelles GW concernées par le gabarit en question, et les listes des bandes de fréquences ou canaux attribués à chaque gabarit permettent alors au serveur LNS 130 de définir quelles bandes de fréquences ou canaux doivent être supportés par chaque passerelle GW. Chaque table d'allocation fréquentielle GWT-F indique alors une liste des bandes de fréquences ou canaux en association avec un identifiant de gabarit d'où provient ladite liste de bandes de fréquences ou canaux, et ce, pour chaque gabarit concerné par la passerelle GW à laquelle réfère ladite table d'allocation fréquentielle GWT-F. Lorsque le système de communication supporte plusieurs hiérarchies de mobilité en parallèle, chaque table d'allocation fréquentielle GWT-F peut en outre inclure l'identifiant de la hiérarchie de mobilité à laquelle chaque gabarit réfère.

Dans une étape 803, le serveur LNS 130 configure chaque passerelle GW de sorte à ce que ladite passerelle GW utilise, pour communiquer par radio avec des terminaux EP, les bandes de fréquences ou canaux qui lui ont été attribués selon la table d'allocation fréquentielle GWT-F associée à ladite passerelle GW. L'étape 803 est par exemple effectuée par envoi d'un message du serveur LNS 130 vers chacune des passerelles GW, en utilisant un format JSON (« JavaScript Object Notation » en anglais). Chaque passerelle GW se configure alors en conséquence.

La **Fig. 9** illustre schématiquement un algorithme, implémenté par le serveur LNS 130, de configuration des terminaux EP afin d'appliquer le plan de fréquences tel que défini par exécution de l'algorithme de la Fig. 7.

Dans une étape 901, le serveur LNS 130 reçoit une requête JoinReq de connexion au système de communication de la part d'un terminal EP. Cette requête JoionReq est relayée jusqu'au serveur LNS 130 par au moins une passerelle GW l'ayant reçue directement de la part du terminal EP. Pour émettre cette requête JoinReq, le terminal EP utilise une bande de fréquences qui est obligatoirement supportée par tout terminal EP et par toute passerelle GW lorsque ce terminal EP ou cette passerelle GW est destiné à être utilisé au sein du système de communication. Par exemple, selon la technologie LoRaWAN, tout terminal EP et toute passerelle GW doivent supporter trois bandes de fréquences par défaut. L'attribution de bandes de fréquences ou canaux à laquelle il est fait référence dans les Figs. 6 à 8 concerne les bandes de fréquences ou canaux autres que ceux supportés par défaut par tout terminal EP et par toute passerelle GW.

Dans une étape 902, le serveur LNS 130 obtient un descriptif du terminal EP en provenance duquel le serveur LNS 130 a reçu la requête JoinReq à l'étape 901. La requête JoinReq reçue à l'étape 901 contient un identifiant du terminal EP. Dans un premier mode de réalisation, le serveur SOE 140 a fourni au préalable au serveur LNS 130 un descriptif de chaque terminal EP susceptible de se connecter au système de communication. Dans un second mode de réalisation, le serveur LNS 130 obtient l'identifiant du terminal EP à partir de la requête JoinReq reçue à l'étape 901, et envoie au serveur SOE 140 un message contenant ledit identifiant afin de recevoir en réponse le descriptif du terminal EP en question. Le descriptif de chaque terminal EP contient une liste de types de mobilité (MobilityType) et une quantité de bandes de fréquences ou canaux à attribuer au terminal EP en question par type de mobilité listé. Le descriptif peut être complété avec des informations supplémentaires, comme par exemple une quantité de répétitions NbRep que le terminal EP est supposé effectuer pour chaque transmission de trame, un débit ascendant maximum, un débit ascendant minimum,... Lorsque le système de communication supporte plusieurs hiérarchies de mobilité en parallèle, le descriptif contient en outre l'identifiant de chaque hiérarchie de mobilité vis-à-vis de laquelle ledit terminal EP doit être configuré. Le descriptif du terminal EP tel que fourni par le serveur SOE 140 dépend par exemple d'un abonnement effectivement souscrit par un utilisateur dudit terminal EP auprès de l'opérateur de service.

Dans une étape 903, le serveur LNS 130 identifie, à partir du descriptif du terminal EP obtenu à l'étape 902 (avec la liste de types de mobilité), quel est le type de mobilité de plus haut degré hiérarchique à laquelle ledit terminal EP a droit d'accès. Lorsqu'il existe plusieurs types de mobilité de même degré hiérarchique pouvant être identifiés par le serveur LNS 130 dans l'étape 903, le serveur LNS 130 applique une règle prédéfinie pour sélectionner un type de mobilité parmi ceux de même degré hiérarchique pouvant être identifiés par le serveur LNS 130 dans l'étape 903.

Dans une étape 904, le serveur LNS 130 identifie, à partir du type de mobilité identifié à l'étape 902 et à partir de l'arbre de mobilité (instances de types de mobilités), quelles sont les zones de mobilité de plus haut degré hiérarchique à laquelle ledit terminal EP a droit d'accès.

Dans une étape 905, le serveur LNS 130 vérifie si au moins une zone de mobilité a été identifiée à l'étape 904. Si tel est le cas, une étape 906 est effectuée ; sinon, une étape 909 est effectuée.

Dans l'étape 906, le serveur LNS 130 sélectionne une zone de mobilité parmi les zones identifiées à l'étape 904. Ainsi, lorsqu'il existe plusieurs zones de mobilité de même degré hiérarchique pouvant être identifiées par le serveur LNS 130 dans l'étape 904, le serveur LNS 130 applique une règle prédéfinie pour sélectionner une zone de mobilité parmi celles de même degré hiérarchique identifiées par le serveur LNS 130 dans l'étape 904. Par exemple, le serveur LNS 130 sélectionne la zone de mobilité qui est incluse dans un descriptif de gabarit qui présente la plus grande quantité de passerelles GW listées. Selon une autre approche, le serveur LNS 130 sélectionne la zone de mobilité supportée par la plus grande quantité de passerelles GW. Le serveur LNS 130 peut alors en faire la requête auprès du serveur SOE 140 en lui fournissant une liste des zones identifiées à l'étape 904. Selon encore une autre approche, le serveur LNS 130 obtient, de la part de chaque passerelle GW ayant reçu et relayé la requête à laquelle il est fait référence à l'étape 901, une information de niveau de signal reçu RSSI mesuré à la réception de ladite requête par ladite passerelle GW. Le serveur LNS 130 détermine alors une moyenne des niveaux de signal reçu RSSI mesurés à la réception de ladite requête par les passerelles GW de chaque zone de mobilité concernée, et le serveur LNS 130 sélectionne la zone de mobilité présentant la moyenne la plus élevée de niveau de signal reçu RSSI mesuré à la réception de ladite requête.

Dans une étape 907, le serveur LNS 130 sélectionne, selon une règle prédéfinie, au moins une bande de fréquences ou au moins un canal attribué à la zone de mobilité sélectionnée à l'étape 906, grâce à la table de mobilité. Par exemple, le serveur LNS 130 sélectionne aléatoirement au moins une bande de fréquences ou au moins un canal attribué à la zone de mobilité sélectionnée à l'étape 906. Chaque terminal EP ne pouvant supporter qu'une quantité maximum prédéfinie de bandes de fréquences ou de canaux, le serveur LNS 130 sélectionne ainsi une quantité de bandes de fréquences ou de canaux dans l'étape 907, de sorte que, au total, une quantité de bandes de fréquences ou de canaux sélectionnés pour le terminal EP reste inférieure ou égale à la quantité maximum prédéfinie de bandes de fréquences ou de canaux que peut supporter le terminal EP. Par exemple, cette quantité maximum prédéfinie de bandes de fréquences ou de canaux que peut supporter le terminal EP est fixée à treize.

Dans une étape 908, le serveur LNS 130 vérifie si la quantité maximum prédéfinie de bandes de fréquences ou de canaux que peut supporter le terminal EP est atteinte. Si tel est le cas, une étape 911 est effectuée ; sinon, l'étape 909 est effectuée.

Dans l'étape 909, le serveur LNS 130 vérifie si au moins un type de zone de mobilité reste à traiter. Si tel est le cas, une étape 910 est effectuée ; sinon, l'étape 911 est effectuée.

Dans l'étape 910, le serveur LNS 130 identifie quel est le type de mobilité de plus haut degré hiérarchique à laquelle ledit terminal EP a droit d'accès, en excluant chaque type de mobilité précédemment traité dans le cadre de l'exécution de l'algorithme de la Fig. 9 (itérations précédentes des étapes 903 et 910 dans le cadre de l'exécution courante de l'algorithme de la Fig. 9). Ensuite, l'étape 904 est réitérée.

Dans l'étape 911, le serveur LNS 130 configure le terminal EP de sorte à ce que ledit terminal EP utilise, pour communiquer par radio au sein du système de communication, les bandes de fréquences ou canaux qui ont été sélectionnés lors des précédentes itérations de l'étape 907 (dans le cadre de l'exécution courante de l'algorithme de la Fig. 9).

Dans un mode de réalisation particulier, conforme aux formats de messages utilisés dans la technologie LoRaWAN, le serveur LNS 130 configure le terminal EP de la façon suivante. Le serveur LNS 130 informe le terminal EP d'un premier lot de bandes de fréquences ou canaux à utiliser, dans un message JoinAccept en réponse à la requête JoinReq reçue à l'étape 901. Le serveur LNS 130 utilise une passerelle GW comme relais du message JoinAccept. Préférentiellement, conformément aux formats de messages utilisés dans la technologie LoRaWAN, jusqu'à cinq bandes de fréquences ou canaux sont ainsi indiqués dans le message JoinAccept. Le serveur LNS 130 informe ensuite le terminal EP d'un second lot de bandes de fréquences ou canaux à utiliser, dans un ou plusieurs messages complémentaires NewChannelReq. Préférentiellement, conformément aux formats de messages utilisés dans la technologie LoRaWAN, une seule bande de fréquences ou un seul canal est ainsi indiqué dans chaque message complémentaire NewChannelReq. Le serveur LNS 130 procède ainsi jusqu'à ce que ledit terminal EP soit informé de l'intégralité des bandes de fréquences ou canaux qui ont été sélectionnés pour ledit terminal EP lors des précédentes itérations de l'étape 907 (dans le cadre de l'exécution courante de l'algorithme de la Fig. 9). Le terminal EP se configure alors en conséquence.

Dans un autre mode de réalisation particulier, le descriptif du terminal EP obtenu à l'étape 902 comporte une information, fournie par le serveur SOE 140, indiquant si le terminal EP est supposé être fixe (*e.g.* le terminal EP est un capteur fixe dans un service de domotique). Afin de permettre de localiser effectivement un terminal EP fixe, le serveur LNS 130 doit configurer ledit terminal EP avec des bandes de fréquences ou des canaux supportés par au moins trois passerelles GW susceptibles de recevoir les trames ascendantes transmises par ledit terminal EP. Comme expliqué précédemment, le serveur LNS 130 détermine la liste des bandes de fréquences ou des canaux éligibles audit terminal EP. En fonction des passerelles GW qui ont relayé la requête JoinReq pour permettre au serveur LNS 130 de recevoir ladite requête JoinReq à l'étape 901, le serveur LNS 130 détermine les bandes de fréquences ou canaux de cette liste qui ont été attribués à au moins trois passerelles GW parmi les passerelles GW ayant relayé ladite requête JoinReq. Le serveur LNS 130 attribue ces bandes de fréquences ou canaux audit terminal EP. Pour les fréquences non sélectionnées, le serveur LNS 130 attend préférentiellement de recevoir plus de trames ascendantes en provenance dudit terminal EP pour déterminer si de nouvelles passerelles GW ont reçu, et donc relayé, lesdites trames ascendantes. Le serveur LNS 130 détermine si d'autres bandes de fréquences ou canaux de la liste des bandes de fréquences ou des canaux éligibles audit terminal EP ont été attribués à au moins trois passerelles GW parmi les passerelles GW ayant relayé lesdites trames ascendantes. Dans le cas où la quantité de passerelles GW réceptrices de trames ascendantes en provenance dudit terminal EP est toujours strictement inférieure à trois, la localisation effective dudit terminal EP n'est pas possible. L'affectation de bandes de fréquences ou de canaux audit terminal EP s'effectue alors, comme précédemment décrit, sans tenir compte du besoin de localisation du terminal EP. Le serveur LNS 130 émet alors une alerte auprès du serveur SOE 140 afin d'informer ledit serveur SOE 140, et donc l'opérateur de service, que la localisation n'est pas possible pour ledit terminal EP.

## Revendications

1. Procédé de définition et d'application d'un plan de fréquences dans un système de communication tel qu'un système sans-fil moyenne ou longue portée de type LPWAN comportant un serveur (130) et une pluralité de passerelles (120, 121, 122, 123) connectées audit serveur, la pluralité de passerelles utilisant des bandes de fréquences pour effectuer des communications sans-fil avec des terminaux (110, 111) du système de communication, **caractérisé en ce que** le serveur effectue les étapes suivantes :

   - obtenir (501) une description d'une hiérarchie de mobilité dans laquelle des types de mobilité sont hiérarchiquement définis ;
   - obtenir (502) une description d'un arbre de mobilité dans lequel des zones de mobilité sont hiérarchiquement définies, chaque zone de mobilité ayant un type de mobilité en conformité avec la hiérarchie de mobilité ;
   - obtenir (503, 601) des mesures de terrain associées à chaque zone de mobilité définie dans l'arbre de mobilité ;
   - déterminer (603), à partir des mesures de terrain, pour chaque zone de mobilité, une information de pourcentage de temps pendant lequel les mesures de terrain montrent un niveau de signal reçu RSSI inférieur à tel ou tel seuil de niveau de signal reçu RSSI parmi un ensemble prédéfini de seuils de niveau de signal reçu RSSI;

**en ce que** le serveur parcourt l'arbre de mobilité en itérant les étapes suivantes :

- sélectionner (701) la zone de mobilité de plus haut degré hiérarchique non encore traitée ;
- déterminer (702), pour la zone de mobilité sélectionnée, une probabilité moyenne $P_m$ pour chaque bande de fréquences, à partir desdites informations de pourcentage de temps déterminées pour chaque zone de mobilité qui est une feuille de l'arbre et qui est hiérarchiquement rattachée à la zone de mobilité sélectionnée ;
- attribuer (705), pour la zone de mobilité sélectionnée, jusqu'à une quantité P de bandes de fréquences présentant les meilleures probabilités moyennes ;

**en ce que** le serveur effectue les étapes suivantes pour configurer les passerelles vis-à-vis du plan de fréquences :

- obtenir (801) des descriptifs de gabarits de mobilité dans lesquels des regroupements de zones de mobilité sont effectués et dans lesquels, pour chaque regroupement, une liste de passerelles est associée à chaque regroupement pour indiquer quelles passerelles sont destinées à supporter ledit regroupement ;
- configurer (804) chaque passerelle en fonction desdits descriptifs de gabarits et des bandes de fréquences attribuées aux zones de mobilité constituant lesdits regroupements ;

**en ce que**, sur réception (901) de la part d'un terminal d'une requête de connexion au système de communication, le serveur obtient (902) un descriptif du terminal à partir d'un identifiant de terminal inclus dans ladite requête, le descriptif incluant une liste de types de mobilité auxquels ledit terminal a droit d'accès, et le serveur itère les étapes suivantes pour l'intégralité des types de mobilité auxquels ledit terminal a droit d'accès :

- identifier (903, 910) le type de mobilité de plus haut degré hiérarchique ;
- identifier (904) quelles zones de mobilité correspondent audit type de mobilité de plus haut degré hiérarchique identifié ;
- sélectionner (906) une zone de mobilité parmi les zones de mobilité identifiées ;
- attribuer (907) audit terminal au moins une bande de fréquences attribuée à la zone de mobilité sélectionnée ;
et **en ce que** le serveur configure (911) ledit terminal en fonction des bandes de fréquences ainsi attribuées audit terminal.

2. Procédé selon la revendication 1, **caractérisé en ce que** la probabilité moyenne $P_m$ est calculée de la façon suivante :

$$P_m = \frac{\sum_{k=1}^{N} \sum_{j=RSSI_d}^{RSSI_f} T_k(i,j)}{N * \left(RSSI_f - RSSI_d\right)}$$

où $RSSI_d$ est une valeur d'index correspondant à la valeur minimum de seuil de niveau de signal reçu RSSI pour laquelle une valeur de probabilité a été exprimée vis-à-vis de la zone de mobilité considérée, $RSSI_f$ est une valeur d'index correspondant à la valeur maximum de seuil de niveau de signal reçu RSSI pour laquelle une valeur de probabilité a été exprimée vis-à-vis de la zone de mobilité considérée, $N$ est la quantité de zones de mobilité considérées pour le calcul de la probabilité moyenne $P_m$, et $T_k(i,j)$ représente la probabilité associée à la bande de fréquence considérée pour la $k$-ième zone de mobilité parmi lesdites $N$ zones de mobilités pour un seuil de niveau de signal reçu RSSI représenté par une valeur d'index $j$.

3. Procédé selon l'une quelconque des revendications 1 et 2, **caractérisé en ce que**, pour configurer ledit terminal, le serveur effectue les étapes suivantes :

- informer d'un premier lot de bandes de fréquences attribuées au terminal, via un message de réponse à la requête reçue ; et
- informer d'un second lot de bandes de fréquences attribuées au terminal, via un ou plusieurs messages complémentaires.

4. Procédé selon l'une quelconque des revendications 1 à 3, **caractérisé en ce que** des canaux forment des regroupements de bandes de fréquences consécutives, et le serveur attribue les bandes de fréquences sur une base canal.

5. Procédé selon l'une quelconque des revendications 1 à 4, **caractérisé en ce que** le serveur obtient la description de la hiérarchie de mobilité, la description de l'arbre de mobilité, les mesures de terrain, le descriptif de chaque terminal auprès d'un autre serveur (140) externe au système de communication.

6. Procédé selon la revendication 5, **caractérisé en ce que** le serveur vérifie que le type de mobilité de chaque zone de mobilité de l'arbre de mobilité a un degré hiérarchique inférieur au type de mobilité d'une autre zone de mobilité à laquelle ladite zone de mobilité est directement rattachée dans l'arbre de mobilité.

**7.** Procédé selon l'une quelconque des revendications 1 à 6, **caractérisé en ce que** le descriptif de chaque terminal comporte une information indiquant si le terminal est supposé être fixe, et le serveur effectue les étapes suivantes vis-à-vis du terminal ayant émis la requête reçue :

- déterminer la liste des bandes de fréquences éligibles audit terminal ;
- déterminer les bandes de fréquences de cette liste qui ont été attribuées à au moins trois passerelles parmi les passerelles ayant relayé ladite requête ; et
- attribuer les bandes de fréquences ainsi déterminées audit terminal EP.

**8.** Procédé selon la revendication 7, **caractérisé en ce que**, pour les fréquences non sélectionnées de ladite liste des bandes de fréquences éligibles, le serveur attend de recevoir d'autres trames en provenance dudit terminal pour déterminer si de nouvelles passerelles ont relayé lesdites autres trames et ainsi déterminer si d'autres bandes de fréquences de ladite liste des bandes de fréquences éligibles ont été attribuées à au moins trois passerelles parmi les passerelles ayant relayé lesdites autres trames.

**9.** Procédé selon la revendication 8, **caractérisé en ce que**, dans le cas où la quantité de passerelles réceptrices de trames ascendantes en provenance dudit terminal reste strictement inférieure à trois, le serveur émet une alerte.

**10.** Programme d'ordinateur comportant un ensemble d'instructions causant l'exécution, par un processeur (201) d'un serveur (130) destiné à être inclus dans un réseau étendu à longue portée de type LPWAN, le procédé selon l'une quelconque des revendications 1 à 9, lorsque ledit programme d'ordinateur est exécuté par ledit processeur.

**11.** Support de stockage d'informations stockant un programme d'ordinateur comportant un ensemble d'instructions causant l'exécution, par un processeur (201) d'un serveur (130) destiné à être inclus dans un réseau étendu à longue portée de type LPWAN, le procédé selon l'une quelconque des revendications 1 à 9, lorsque ledit programme d'ordinateur est exécuté par ledit processeur.

**12.** Serveur (130) configuré pour définir et appliquer un plan de fréquences dans un système de communication de type LPWAN comportant, outre ledit serveur, une pluralité de passerelles (120, 121, 122, 123) connectées audit serveur, la pluralité de passerelles utilisant des bandes de fréquences pour effectuer des communications sans-fil avec des terminaux (110, 111) du système de communication, **ca-**

**ractérisé en ce que** le serveur est configuré pour :

- obtenir (501) une description d'une hiérarchie de mobilité dans laquelle des types de mobilité sont hiérarchiquement définis ;
- obtenir (502) une description d'un arbre de mobilité dans lequel des zones de mobilité sont hiérarchiquement définies, chaque zone de mobilité ayant un type de mobilité en conformité avec la hiérarchie de mobilité ;
- obtenir (503, 601) des mesures de terrain associées à chaque zone de mobilité définie dans l'arbre de mobilité ;
- déterminer (603), à partir des mesures de terrain, pour chaque zone de mobilité, une information de pourcentage de temps pendant lequel les mesures de terrain montrent un niveau de signal reçu RSSI inférieur à tel ou tel seuil de niveau de signal reçu RSSI parmi un ensemble prédéfini de seuils de niveau de signal reçu RSSI;

**en ce que** le serveur est configuré pour parcourir l'arbre de mobilité en itérant les étapes suivantes :

- sélectionner (701) la zone de mobilité de plus haut degré hiérarchique non encore traitée ;
- déterminer (702), pour la zone de mobilité sélectionnée, une probabilité moyenne $P_m$ pour chaque bande de fréquences, à partir desdites informations de pourcentage de temps déterminées pour chaque zone de mobilité qui est une feuille de l'arbre et qui est hiérarchiquement rattachée à la zone de mobilité sélectionnée ;
- attribuer (705), pour la zone de mobilité sélectionnée, jusqu'à une quantité P de bandes de fréquences présentant les meilleures probabilités moyennes ;

**en ce que** le serveur est configuré pour effectuer les étapes suivantes pour configurer les passerelles vis-à-vis du plan de fréquences :

- obtenir (801) des descriptifs de gabarits de mobilité dans lesquels des regroupements de zones de mobilité sont effectués et dans lesquels, pour chaque regroupement, une liste de passerelles est associée à chaque regroupement pour indiquer quelles passerelles sont destinées à supporter ledit regroupement ;
- configurer (804) chaque passerelle en fonction desdits descriptifs de gabarits et des bandes de fréquences attribuées aux zones de mobilité constituant lesdits regroupements ;

**en ce que**, sur réception (901) de la part d'un terminal d'une requête de connexion au système de communication, le serveur est configuré pour obtenir (902) un descriptif du terminal à partir d'un identifiant de terminal inclus dans ladite requête, le descriptif incluant une liste de types de mobilité auxquels ledit terminal a droit d'accès, et pour itérer les étapes suivantes pour l'intégralité des types de mobilité auxquels ledit terminal a droit d'accès :

- identifier (903, 910) le type de mobilité de plus haut degré hiérarchique ;
- identifier (904) quelles zones de mobilité correspondent audit type de mobilité de plus haut degré hiérarchique identifié ;
- sélectionner (906) une zone de mobilité parmi les zones de mobilité identifiées ;
- attribuer (907) audit terminal au moins une bande de fréquences attribuée à la zone de mobilité sélectionnée ;

et **en ce que** le serveur est configuré pour configurer (911) ledit terminal en fonction des bandes de fréquences ainsi attribuées audit terminal.


**Patentansprüche**

1. Verfahren zur Definition und zur Anwendung eines Frequenzplans in einem Kommunikationssystem wie einem drahtlosen System mittlerer oder großer Reichweite vom Typ LPWAN, das einen Server (130) und eine Vielzahl von mit dem Server verbundenen Gateways (120, 121, 122, 123) aufweist, wobei die Vielzahl von Gateways Frequenzbänder verwendet, um drahtlose Kommunikationen mit Endgeräten (110, 111) des Kommunikationssystems auszuführen, **dadurch gekennzeichnet, dass** der Server die folgenden Schritte ausführt:

- Erhalt (501) einer Beschreibung einer Mobilitätshierarchie, in der Mobilitätstypen hierarchisch definiert sind;
- Erhalt (502) einer Beschreibung eines Mobilitätsbaums, in dem Mobilitätzonen hierarchisch definiert sind, wobei jede Mobilitätszone einen Mobilitätstyp in Übereinstimmung mit der Mobilitätshierarchie hat;
- Erhalt (503, 601) von jeder im Mobilitätsbaum definierten Mobilitätszone zugeordneten Feldmesswerten;
- Bestimmen (603) für jede Mobilitätszone, ausgehend von den Feldmesswerten, einer Information über den Zeitprozentsatz, während dessen die Feldmesswerte eine Empfangssignalstärke RSSI zeigen, die niedriger ist als diese oder jene Empfangssignalstärkenschwelle RSSI unter einer vorbestimmten Einheit von Empfangssignalstärkenschwellen RSSI;

dass der Server den Mobilitätsbaum durchläuft, indem er die folgenden Schritte wiederholt:

- Auswahl (701) der Mobilitätszone höchster hierarchischen Ordnung, die noch nicht verarbeitet wurde;
- Bestimmen (702) einer mittleren Wahrscheinlichkeit $P_m$ für jedes Frequenzband für die ausgewählte Mobilitätszone ausgehend von den Zeitprozentsatz-Informationen, die für jede Mobilitätszone bestimmt sind, die ein Blatt des Baums ist und die hierarchisch an die ausgewählte Mobilitätszone angegliedert ist;
- Zuweisen (705), für die ausgewählte Mobilitätszone, bis zu einer Menge P von Frequenzbändern, die die besten mittleren Wahrscheinlichkeiten aufweisen;

dass der Server die folgenden Schritte ausführt, um die Gateways gegenüber dem Frequenzplan zu konfigurieren:

- Erhalt (801) von Beschreibungen von Mobilitätsformaten, in denen Gruppierungen von Mobilitätzonen ausgeführt werden, und in denen für jede Gruppierung eine Liste von Gateways jeder Gruppierung zugeordnet ist, um anzuzeigen, welche Gateways dazu bestimmt sind, die Gruppierung zu unterstützen;
- Konfigurieren (804) jedes Gateways abhängig von den Beschreibungen von Formaten und von den den die Gruppierungen bildenden Mobilitätszonen zugewiesenen Frequenzbändern;

dass bei Empfang (901) einer Verbindungsanforderung mit dem Kommunikationssystem von einem Endgerät der Server eine Beschreibung des Endgeräts ausgehend von einer Endgerätkennung erhält (902), die in der Anforderung enthalten ist, wobei die Beschreibung eine Liste von Mobilitätstypen enthält, auf die das Endgerät ein Zugriffsrecht hat, und der Server die folgenden Schritte für die Gesamtheit der Mobilitätstypen wiederholt, auf die das Endgerät ein Zugriffsrecht hat:

- Erkennen (903, 910) des Mobilitätstyps höchster hierarchische Ordnung;
- Erkennen (904), welche Mobilitätszonen dem erkannten Mobilitätstyp höchster hierarchischer Ordnung entsprechen;
- Auswahl (906) einer Mobilitätszone unter den erkannten Mobilitätszonen;
- Zuweisen (907) mindestens eines der ausgewählten Mobilitätszone zugewiesenen Frequenzbands zum Endgerät;

und dass der Server das Endgerät abhängig von den so dem Endgerät zugewiesenen Frequenzbändern konfiguriert (911).

**2.** Verfahren nach Anspruch 1, **dadurch gekennzeichnet, dass** die mittlere Wahrscheinlichkeit $P_m$ folgendermaßen berechnet wird:

$$P_m = \frac{\sum_{k=1}^{N} \sum_{j=RSSI_d}^{RSSI_f} T_k(i,j)}{N * (RSSI_f - RSSI_d)}$$

wobei $RSSI_d$ ein Indexwert ist, der dem minimalen Empfangssignalstärkenschwellwert RSSI entspricht, für den ein Wahrscheinlichkeitswert gegenüber der betreffenden Mobilitätszone ausgedrückt wurde, $RSSI_f$ ein Indexwert ist, der dem maximalen Empfangssignalstärkenschwellwert RSSI entspricht, für den ein Wahrscheinlichkeitswert gegenüber der betreffenden Mobilitätszone ausgedrückt wurde, N die Menge von für die Berechnung der mittleren Wahrscheinlichkeit $P_m$ betrachteten Mobilitätszonen ist, und $T_k(i,j)$ die Wahrscheinlichkeit darstellt, die dem betrachteten Frequenzband für die k-te Mobilitätszone unter den N Mobilitätszonen für eine durch einen Indexwert j dargestellte Empfangssignalstärkenschwelle RSSI zugeordnet ist.

**3.** Verfahren nach einem der Ansprüche 1 und 2, **dadurch gekennzeichnet, dass** der Server zum Konfigurieren des Endgeräts die folgenden Schritte ausführt:

- Informieren über ein erstes Paket von dem Endgerät zugewiesenen Frequenzbändern mittels einer Antwortnachricht auf die empfangene Anforderung; und
- Informieren über ein zweites Paket von dem Endgerät zugewiesenen Frequenzbändern mittels einer oder mehrerer komplementärer Nachrichten.

**4.** Verfahren nach einem der Ansprüche 1 bis 3, **dadurch gekennzeichnet, dass** Kanäle Gruppierungen von aufeinanderfolgenden Frequenzbändern bilden, und der Server die Frequenzbänder auf einer Kanalbasis zuteilt.

**5.** Verfahren nach einem der Ansprüche 1 bis 4, **dadurch gekennzeichnet, dass** der Server die Beschreibung der Mobilitätshierarchie, die Beschreibung des Mobilitätsbaums, die Feldmesswerte, die Beschreibung jedes Endgeräts bei einem anderen Server (140) außerhalb des Kommunikationssystems erhält.

**6.** Verfahren nach Anspruch 5, **dadurch gekennzeichnet, dass** der Server überprüft, dass der Mobilitätstyp jeder Mobilitätszone des Mobilitätsbaums eine hierarchische Ordnung niedriger als der Mobilitätstyp einer anderen Mobilitätszone hat, mit der die Mobilitätszone im Mobilitätsbaum direkt verbunden ist.

**7.** Verfahren nach einem der Ansprüche 1 bis 6, **dadurch gekennzeichnet, dass** die Beschreibung jedes Endgeräts eine Information aufweist, die anzeigt, dass vom Endgerät angenommen wird, dass es ortsfest ist, und der Server die folgenden Schritte gegenüber dem Endgerät ausführt, das die empfangene Anforderung gesendet hat:

- Bestimmen der Liste der wählbaren Frequenzbänder für das Endgerät;
- Bestimmen der Frequenzbänder dieser Liste, die mindestens drei Gateways unter den Gateways zugewiesen wurden, die die Anforderung weitergeleitet haben; und
- Zuweisen der so bestimmten Frequenzbänder zum Endgerät EP.

**8.** Verfahren nach Anspruch 7, **dadurch gekennzeichnet, dass**, für die nicht aus der Liste der wählbaren Frequenzbänder ausgewählten Frequenzen, der Server abwartet, andere Rahmen vom Endgerät zu empfangen, um zu bestimmen, ob neue Gateways die anderen Rahmen weitergeleitet haben, und so zu bestimmen, ob andere Frequenzbänder der Liste der wählbaren Frequenzbänder mindestens drei Gateways unter den Gateways zugewiesen wurden, die die anderen Rahmen weitergeleitet haben.

**9.** Verfahren nach Anspruch 8, **dadurch gekennzeichnet, dass** in dem Fall, in dem die Menge von Gateways, die vom Endgerät kommende Aufwärtsrahmen empfangen, strikt niedriger als drei bleibt, der Server einen Alarm sendet.

**10.** Computerprogramm, das eine Einheit von Anweisungen aufweist, die die Ausführung, durch einen Prozessor (201) eines Servers (130), der dazu bestimmt ist, in einem erweiterten Netz großer Reichweite vom Typ LPWAN enthalten zu sein, des Verfahrens nach einem der Ansprüche 1 bis 9 veranlassen, wenn das Computerprogramm vom Prozessor ausgeführt wird.

**11.** Informationsspeicherträger, der ein Computerprogramm speichert, das eine Einheit von Anweisungen aufweist, die die Ausführung, durch einen Prozessor (201) eines Servers (130), der dazu bestimmt ist, in einem erweiterten Netz großer Reichweite vom Typ LPWAN enthalten zu sein, des Verfahrens nach einem der Ansprüche 1 bis 9 veranlassen, wenn das Computerprogramm vom Prozessor ausgeführt wird.

**12.** Server (130), der konfiguriert ist, einen Frequenzplan in einem Kommunikationssystem vom Typ LPWAN zu definieren und anzuwenden, das außer dem Server eine Vielzahl von Gateways (120, 121, 122, 123) aufweist, die mit dem Server verbunden sind, wobei die Vielzahl von Gateways Frequenzbänder verwendet, um drahtlose Kommunikationen mit Endgeräten (110, 111) des Kommunikationssystems auszuführen, **dadurch gekennzeichnet, dass** der Server konfiguriert ist:

    - eine Beschreibung einer Mobilitätshierarchie zu erhalten (501), in der Mobilitätstypen hierarchisch definiert sind;
    - eine Beschreibung eines Mobilitätsbaums zu erhalten (502), in dem Mobilitätszonen hierarchisch definiert sind, wobei jede Mobilitätszone einen Mobilitätstyp in Übereinstimmung mit der Mobilitätshierarchie hat;
    - Feldmesswerte zu erhalten (503, 601), die jeder im Mobilitätsbaum definierten Mobilitätszone zugeordnet sind;
    - ausgehend von den Feldmesswerten für jede Mobilitätszone eine Information über einen Zeitprozentsatz zu bestimmen (603), während dessen die Feldmesswerte eine Empfangssignalstärke RSSI niedriger als diese oder jene Empfangssignalstärkenschwelle RSSI unter einer vordefinierten Einheit von Empfangssignalstärkenschwellen RSSI zeigen;

dass der Server konfiguriert ist, den Mobilitätsbaum zu durchlaufen, indem er die folgenden Schritte wiederholt:

    - Auswählen (701) der Mobilitätszone höchster hierarchischer Ordnung, die noch nicht verarbeitet wurde;
    - Bestimmen (702), für die ausgewählte Mobilitätszone, einer mittleren Wahrscheinlichkeit $P_m$ für jedes Frequenzband, ausgehend von den Zeitprozentsatzinformationen, die für jede Mobilitätszone bestimmt sind, die ein Blatt des Baums ist und die hierarchisch an die ausgewählte Mobilitätszone angegliedert ist;
    - Zuweisen (705) bis zu einer Menge P von Frequenzbändern für die ausgewählte Mobilitätszone, die die besten mittleren Wahrscheinlichkeiten aufweisen;

dass der Server konfiguriert ist, die folgenden Schritte auszuführen, um die Gateways gegenüber dem Frequenzplan zu konfigurieren:

    - Erhalt (801) der Beschreibungen von Mobilitätsformaten, in denen Gruppierungen von Mobilitätszonen ausgeführt werden und in denen für jede Gruppierung eine Liste von Gateways jeder Gruppierung zugeordnet wird, um anzuzeigen, welche Gateways dazu bestimmt sind, die Gruppierung zu unterstützen;
    - Konfigurieren (804) jedes Gateways abhängig von den Beschreibungen von Formaten und von den den die Gruppierungen bildenden Mobilitätszonen zugewiesenen Frequenzbändern;

dass bei Empfang (901) einer Verbindungsanforderung mit dem Kommunikationssystem von einem Endgerät der Server konfiguriert ist, eine Beschreibung des Endgeräts ausgehend von einer Kennung des Endgeräts zu erhalten (902), die in der Anforderung enthalten ist, wobei die Beschreibung eine Liste von Mobilitätstypen enthält, auf die das Endgerät ein Zugriffsrecht hat, und die folgenden Schritte für die Gesamtheit der Mobilitätstypen zu wiederholen, auf die das Endgerät ein Zugriffsrecht hat:

    - Erkennen (903, 910) des Mobilitätstyp höchster hierarchischer Ordnung;
    - Erkennen (904), welche Mobilitätszonen dem erkannten Mobilitätstyp höchster hierarchischer Ordnung entsprechen;
    - Auswählen (906) einer Mobilitätszone unter den erkannten Mobilitätszonen;
    - Zuweisen (907) mindestens eines Frequenzbands zum Endgerät, das der ausgewählten Mobilitätszone zugewiesen ist;

und dass der Server konfiguriert ist, das Endgerät abhängig von den so dem Endgerät zugewiesenen Frequenzbändern zu konfigurieren (911).

**Claims**

1. Method for defining and applying a frequency plan in a communication system such as a medium or long range wireless system of the LPWAN type comprising a server (130) and a plurality of gateways (120, 121, 122, 123) connected to said server, the plurality of gateways using frequency bands for making wireless communications with terminals (110, 111) in the communication system, **characterised in** the server performs the following steps:

    - obtaining (501) a description of a mobility hierarchy in which mobility types are hierarchically defined;
    - obtaining (502) a description of a mobility tree in which the mobility areas are hierarchically defined, each mobility area having a mobility type in conformity with the mobility hierarchy;
    - obtaining (503, 601) terrain measurements associated with each mobility area defined in the mobility tree;
    - determining (603), from the terrain measurements, for each mobility area, information on the percentage of time during which the terrain measurements show a received signal level RSSI lower than such and such a received signal level RSSI threshold from a predefined set of received signal level RSSI thresholds;

in that the server runs through the mobility tree by iterating the following steps:

- selecting (701) the mobility area with the highest hierarchical degree not yet processed;
- determining (702), for the mobility area selected, a mean probability $P_m$ for each frequency band, from said time-percentage information determined for each mobility area that is a leaf of the tree and is hierarchically attached to the mobility area selected;
- allocating (705), for the mobility area detected, up to a quantity P of frequency bands having the best mean probabilities;

in that the server performs the following steps for configuring the gateways vis-à-vis the frequency plan:

- obtaining (801) descriptions of mobility ranges in which groupings of mobility areas are made and in which, for each grouping, a list of gateways is associated with each grouping in order to indicate which gateways are intended to support said grouping;
- configuring (804) each gateway according to said descriptions of ranges and frequency bands allocated to the mobility areas constituting said groupings;

in that, on reception (901) from a terminal of a request for connection to the communication system, the server obtains (902) a description of the terminal from a terminal identifier included in said request, the description including a list of mobility types to which said terminal has a right of access, and the server iterates the following steps for all the mobility types to which said terminal has a right of access:

- identifying (903, 910) the mobility type with the highest hierarchical degree;
- identifying (904) which mobility areas correspond to said mobility type with the highest hierarchical degree identified;
- selecting (906) a mobility area from the mobility areas identified;
- allocating (907) to said terminal at least one frequency band allocated to the mobility area selected;

and in that the server configures (911) said terminal according to the frequency bands thus allocated to said terminal.

2. Method according to claim 1, **characterised in that** the mean probability $P_m$ is calculated as follows:

$$P_m = \frac{\sum_{k=1}^{N} \sum_{j=RSSI_d}^{RSSI_f} T_k(i,j)}{N * \left(RSSI_f - RSSI_d\right)}$$

where $RSSI_d$, is an index value corresponding to the minimum received signal level RSSI threshold value for which a probability value has been expressed vis-à-vis the mobility area in question, $RSSI_f$ is an index value corresponding to the maximum received signal level RSSI threshold value for which a probability value has been expressed vis-à-vis the mobility area in question, N is the quantity of mobility areas considered for calculating the mean probability $P_m$, and $T_k(i,j)$ represents the probability associated with the frequency band in question for the $k^{th}$ mobility area among said N mobility areas for a received signal level RSSI threshold represented by an index value j.

3. Method according to either claim 1 or claim 2, **characterised in that**, to configure said terminal, the server performs the following steps:

- informing a first lot of frequency bands allocated to the terminal, via a message responding to the request received; and
- informing a second lot of frequency bands allocated to the terminal, via one or more supplementary messages.

4. Method according to any of claims 1 to 3, **characterised in that** channels form groupings of consecutive frequency bands, and the server allocates the frequency bands to a channel base.

5. Method according to any of claims 1 to 4, **characterised in that** the server obtains the description of the mobility hierarchy, the description of the mobility tree, the terrain measurements and the description of each terminal from another server (140) external to the communication system.

6. Method according to claim 5, **characterised in that** the server checks that the mobility type of each mobility area of the mobility tree has a hierarchical degree lower than the mobility type of another mobility area to which said mobility area is directly attached in the mobility tree.

7. Method according to any of claims 1 to 6, **characterised in that** the description of each terminal comprises information indicating whether the terminal is supposed to be fixed, and the server performs the following steps vis-à-vis the terminal that sent the request received:

- determining the list of frequency bands eligible for said terminal;
- determining the frequency bands in this list that were allocated to at least three gateways among the gateways that relayed said request; and
- allocating the frequency bands thus determined to said EP terminal.

8. Method according to claim 7, **characterised in that**, for the frequencies not selected in said list of eligible frequency bands, the server waits until it receives other frames coming from said terminal in order to determine whether new gateways have relayed said other frames and thus determine whether other frequency bands in said list of the eligible frequency bands have been allocated to at least three gateways among the gateways that relayed said other frames.

9. Method according to claim 8, **characterised in that**, in the case where the quantity of gateways receiving uplink frames coming from said terminal remains strictly less than three, the server sends an alert.

10. Computer program containing a set of instructions causing the execution, by a processor (201) of a server (130) intended to be included in a long-range extended network of the LPWAN type, of the method according to any of claims 1 to 9, when said computer program is executed by said processor.

11. Information storage medium storing a computer program containing a set of instructions causing the execution, by a processor (201) of a server (130) intended to be included in a long-range extended network of the LPWAN type, of the method according to any of claims 1 to 9, when said computer program is executed by said processor.

12. Server (130) configured so as to define and apply a frequency plan in a communication system of the LPWAN type comprising, apart from said server, a plurality of gateways (120, 121, 122, 123) connected to said server, the plurality of gateways using frequency bands for effecting wireless communications with terminals (110, 111) in the communication system, **characterised in that** the server is configured to:

- obtain (501) a description of a mobility hierarchy in which mobility types are hierarchically defined;
- obtain (502) a description of a mobility tree in which mobility areas are hierarchically defined, each mobility area having a mobility type in conformity with the mobility hierarchy;
- obtain (503, 601) terrain measurements associated with each mobility area defined in the mobility tree;

- determine (603), from the terrain measurements, for each mobility area, information on the percentage of time during which the terrain measurements show a received signal level RSSI lower than such and such a received signal level RSSI threshold from a predefined set of received signal level RSSI thresholds;

**in that** the server is configured so as to run though the mobility tree by iterating the following steps:

- selecting (701) the mobility area with the highest hierarchical degree not yet processed;
- determining (702), for the mobility area selected, a mean probability $P_m$ for each frequency band, from said time-percentage information determined for each mobility area that is a leaf of the tree and is hierarchically attached to the mobility area selected;
- allocating (705), for the mobility area selected, up to a quantity P of frequency bands having the best mean probabilities;

**in that** the server is configured so as to perform the following steps for configuring the gateways vis-à-vis the frequency plan:

- obtaining (801) descriptions of mobility ranges in which groupings of mobility areas are made and in which, for each grouping, a list of gateways is associated with each grouping in order to indicate which gateways are intended to support said grouping;
- configuring (804) each gateway according to said descriptions of ranges and frequency bands allocated to the mobility areas constituting said groupings;

**in that**, on reception from a terminal of a request for connection to the communication system, the server is configured to obtain (902) a description of the terminal from a terminal identifier included in said request, the description including a list of mobility types to which said terminal has a right of access, and to iterate the following steps for all the mobility types to which said terminal has a right of access:

- identifying (903, 910) the mobility type with the highest hierarchical degree;
- identifying (904) which mobility areas correspond to said mobility type with the highest hierarchical degree identified;
- selecting (906) a mobility area from the mobility areas identified;
- allocating (907) to said terminal at least one frequency band allocated to the mobility area selected;

and **in that** the server is configured to configure (911) said terminal according to the frequency bands thus allocated to said terminal.

Fig. 1

Fig. 2

| N0 | 0 |
|---|---|

| N1_1 | PN0 |
|---|---|

| N1_2 | PN0 |
|---|---|

| N2_1 | PN1_1 |
|---|---|

| N2_2 | PN1_2 |
|---|---|

| N3_1 | PN2_1 |
|---|---|

| N4_1 | PN3_1 |
|---|---|

| N5_1 | PN4_1 |
|---|---|

Fig. 3

| MA | N0 | F | PTR | SI |
|----|----|---|-----|-----|

401

| MA | N1_2 | F | PTR | SI |
|----|------|---|-----|-----|

441

411

| MA | N1_1 | F | PTR | SI |
|----|------|---|-----|-----|

| MA | N2_2 | F | PTR | SI |
|----|------|---|-----|-----|

442

421

| MA | N2_1 | F | PTR | SI |
|----|------|---|-----|-----|

| MA | N2_1 | F | PTR | SI |
|----|------|---|-----|-----|

431

| MA | N4_1 | F | PTR | SI |
|----|------|---|-----|-----|

422

| MA | N3_1 | F | PTR | SI |
|----|------|---|-----|-----|

432

| MA | N4_1 | F | PTR | SI |
|----|------|---|-----|-----|

433

| MA | N5_1 | F | PTR | SI |
|----|------|---|-----|-----|

434

Fig. 4

Obtention d'une description de hiérarchie de mobilité

501

Obtention d'une description d'arbre de mobilité

502

Obtention de mesures de terrain

503

Etablissement d'un plan de fréquences en fonction de l'arbre de mobilité et des mesures de terrain

504

Application du plan de fréquences

505

Fig. 5

Obtention de mesures de terrain RSSI

601

Obtention d'informations de regroupements de bandes de fréquences

602

Détermination d'un pourcentage de temps de mesure pour lequel les mesures de terrain sont inférieures ou égal à des valeurs de seuil prédéterminées, par regroupement de bandes de fréquences

603

Création / Mise à jour d'un tableau de statistiques de probabilités vs RSSI

604

Fig. 6

701     Sélection d'une zone de mobilité

702     Détermination d'une probabilité moyenne par bande de fréquences

703     Sélection jusqu'à P fréquences en fonction des probabilités moyennes déterminées

non   Autre zone de mobilité ?   oui    704

705     Création / Mise à jour d'une table de mobilité

Fig. 7

801     Obtention de descriptifs de gabarits de mobilité

802     Détermination des bandes de fréquence pour chaque gabarit de mobilité

803     Création d'une table d'allocation fréquentielle pour chaque passerelle

804     Configuration de chaque passerelle

Fig. 8

```
┌─────────────────────────────────────────┐
│     Réception d'une requête de connexion │
901 │      de la part d'un terminal            │
└─────────────────────────────────────────┘
                    │
                    ▼
┌─────────────────────────────────────────┐
902 │   Obtention d'un descriptif du terminal  │
└─────────────────────────────────────────┘
                    │
                    ▼
┌─────────────────────────────────────────┐
│     Identification d'un type de mobilité │
903 │           de plus haut degré            │
└─────────────────────────────────────────┘
                    │
                    ▼
┌─────────────────────────────────────────┐
│     Identification de zone(s) de mobilité│
904 │           correspondante(s)             │
└─────────────────────────────────────────┘
                    │
         non        ▼            oui
        ╱─────── Zone(s) de mobilité identifiée ? ───────╲
       905                                                │
                                                          ▼
                            ┌─────────────────────────────────────────┐
906 │       Sélection d'une zone de mobilité   │
                            └─────────────────────────────────────────┘
                                          │
                                          ▼
                            ┌─────────────────────────────────────────┐
907 │  Sélection d'au moins une bande de fréquence │
                            └─────────────────────────────────────────┘
                                          │
              non                         ▼              oui
             ╱─────────────── Maximum atteint ? ───────────────╲
                                                        908
                                          │
              oui                         ▼              non
             ╱────────────── Autre type de mobilité ? ──────────╲
                                                        909
                                          │
                                          ▼
910 ┌─────────────────────────────────────────┐
    │    Sélection d'un autre type de mobilité │
    └─────────────────────────────────────────┘
                    │
                    ▼
┌─────────────────────────────────────────┐
911 │        Configuration du terminal         │
└─────────────────────────────────────────┘
```

Fig. 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LORA ALLIANCE.** *Un aperçu technique de LoRaWan, Qu'est-ce que c'est?,* 31 Mai 2016, http://www.semtech.com/wireless-rf/iot/LoRaWAN101_final.pdf